# EUROPEAN PATENT SPECIFICATION

(11) **EP 3 602 630 B1**
(45) Date of publication and mention of the grant of the patent: **20.11.2024**
(21) Application number: 17903624.9
(22) Date of filing: 22.08.2017
(51) Int. Cl.: H01L 27/15, H01L 33/62

(54) **DISPLAY DEVICE USING SEMICONDUCTOR LIGHT EMITTING DEVICE**
ANZEIGEVORRICHTUNG MIT LICHTEMITTIERENDEM HALBLEITERBAUELEMENT
DISPOSITIF D'AFFICHAGE UTILISANT UN DISPOSITIF ÉLECTROLUMINESCENT À SEMICONDUCTEUR

(30) Priority: 27.03.2017 KR 20170038587
(43) Date of publication of application: 05.02.2020
(73) Proprietor: LG Electronics Inc., Seoul 07336 (KR)
(72) Inventor: CHANG, Younghak, Seoul 06772 (KR)
(74) Representative: Vossius & Partner Patentanwälte Rechtsanwälte mbB
(86) International application number: PCT/KR2017/009159
(87) International publication number: WO 2018/182108

(56) References cited:
- WO-A1-2017/037475
- US-A1- 2006 240 578
- US-A1- 2007 263 134
- US-A1- 2014 120 644
- US-A1- 2014 346 475
- US-A1- 2014 367 633
- US-A1- 2015 054 008
- US-A1- 2015 318 328
- US-B1- 8 791 474

## Description

### Technical Field

The present disclosure relates to a display device, and more particularly, to a display device using a semiconductor light emitting device.

### Background Art

In recent years, display devices having excellent characteristics such as low profile, flexibility and the like have been developed in the display technical field. Currently commercialized main displays are represented by liquid crystal displays (LCDs) and active matrix organic light emitting diodes (AMOLEDs).

However, there exist problems such as a slow response time, difficult implementation of flexibility in case of LCDs, and there exist drawbacks such as short life span, poor yield as well as low flexibility in case of AMOLEDs. Further, light emitting diodes (LEDs) are well known light emitting devices for converting an electrical current to light, and have been used as a light source for displaying an image in an electronic device including information communication devices since red LEDs using GaAsP compound semiconductors were made commercially available in 1962, together with a GaP:N-based green LEDs. Accordingly, the semiconductor light emitting devices may be used to implement a flexible display, thereby presenting a scheme for solving the problems.

When a display device using a semiconductor light emitting device is implemented, some semiconductor light emitting devices have defects, and the development for a method of replacing a defective semiconductor light emitting device with a semiconductor light emitting device without any defect has been actively performed. More specifically, when a defect occurs in some semiconductor light emitting devices on a substrate on which a semiconductor light emitting device is disposed, there are two methods for solving the problem.

One method is a replacement repair method in which a defective semiconductor light emitting device is removed, and then a new semiconductor light emitting device is attached thereto. Another method is a redundancy repair method in which two or more cells having redundant cells are disposed in the unit cell, and an electrical connection of an NG cell (i.e., defective semiconductor light emitting device) corresponding to a defective semiconductor light emitting device is cut off, and only the remaining cells included in the unit cell are driven.

In the replacement repair method, the technical difficulty is high, and thus additional facility investment and a separate chip design are required, resulting in an increase in cost. Further, the redundancy repair method is a method of selectively transferring a number of chips greater than twice the number of chips and a chip having a size of at most two times smaller, and the process of selective transfer has high level difficulty.

US 2014/367633 A1 and US 8 791 474 B1 are prior art documents disclosing a repair method for a display in which the wiring electrode is adapted to account for defective LED chips. WO 2017/037475 A1 is a prior art document disclosing a replacement repair method for a display, and a LED chip having plural light-emitting regions, found as being less likely to be defective and thus reducing the number of repair and transfer steps when manufacturing a display.

### Disclosure of Invention

### Technical Problem

An object of the present disclosure is to provide a novel fabrication process for implementing a flexible display device.

Another object of the present disclosure is to provide a structure capable of easily removing and replacing a defective semiconductor light emitting device using a redundancy repair method.

### Solution to Problem

To achieve these and other advantages and in accordance with the purpose of the present invention, as embodied and broadly described herein, the present invention provides in one aspect a display device according to claim 1.

The present invention also provides a corresponding method of manufacturing a display device.

Further scope of applicability of the present invention will become apparent from the detailed description given hereinafter. However, the detailed description and specific examples, while indicating preferred embodiments of the invention, are given by illustration only, since various changes and modifications within the scope of the invention as defined by the appended claims will become apparent to those skilled in the art from this detailed description.

### Advantageous Effects of Invention

According to the present disclosure having the foregoing configuration, a plurality of semiconductor light emitting devices that share at least one semiconductor layer are included in one unit cell (sub-pixel portion). In other words, the unit cell can be provided with a plurality of semiconductor light emitting devices that share one semiconductor layer other than a plurality of physically separated semiconductor light emitting devices, thereby reducing the complexity of the process of transferring them to a substrate.

Also, an empty space can be provided in the unit cell, and a new semiconductor light emitting device can be disposed in the empty space provided in the unit cell including a defective semiconductor light emitting device. Therefore, even when a defective semiconductor light emitting device is included in the unit cell, the display device according to the present disclosure may additionally arrange a semiconductor light emitting device that can replace the semiconductor light emitting device, thereby facilitating the replacement of the defective semiconductor light emitting device.

In addition, a plurality of semiconductor light emitting devices included in the unit cell and sub-electrodes branched respectively into empty spaces can be provided to remove a defective semiconductor light emitting device or not to perform additional wiring even when a new semiconductor light emitting device is disposed in an empty space, thereby more conveniently removing and replacing the semiconductor light emitting device.

### Brief Description of Drawings

FIG. 1 is a conceptual view illustrating an embodiment of a display device using a semiconductor light emitting device of a comparative example not forming part of the invention as claimed;
FIG. 2 is a partially enlarged view of a portion A in FIG. 1;
FIGS. 3A and 3B are cross-sectional views taken along lines B-B and C-C in FIG 2;
FIG. 4 is a conceptual view illustrating a flip chip type semiconductor light emitting device in FIG. 3;
FIGS. 5A through 5C are conceptual views illustrating various forms of implementing colors in connection with a flip chip type semiconductor light emitting device;
FIG. 6 is a cross-sectional view illustrating a method of fabricating a display device using a semiconductor light emitting device of a comparative example not forming part of the invention as claimed;
FIG. 7 is a perspective view illustrating another embodiment of a display device using a semiconductor light emitting device of a comparative example not forming part of the invention as claimed;
FIG. 8 is a cross-sectional view taken along line C-C in FIG. 7;
FIG. 9 is a conceptual view illustrating a vertical semiconductor light emitting device in FIG. 8;
FIGS. 10, 11, and 12 are enlarged views illustrating a portion A in FIG. 1 illustrating an embodiment according to the invention, to which a semiconductor light emitting device having a novel structure according to the present disclosure is applied;
FIGS. 13, 14 and 15 are conceptual views illustrating a semiconductor light emitting device according to the invention;
FIGS. 16 and 17 are conceptual views illustrating a semiconductor light emitting device according to another example of the invention; and
FIGS. 18 and 19 are enlarged views illustrating a portion A in FIG. 1 illustrating another embodiment of the invention to which a semiconductor light emitting device having a novel structure according to another embodiment of the invention is applied.

### Mode for the Invention

Hereinafter, the embodiments disclosed herein will be described in detail with reference to the accompanying drawings, and the same or similar elements are designated with the same numeral references regardless of the numerals in the drawings and their redundant description will be omitted. A suffix "module" or "unit" used for constituent elements disclosed in the following description is merely intended for easy description of the specification, and the suffix itself does not give any special meaning or function. Also, it should be noted that the accompanying drawings are merely illustrated to easily explain the concept of the invention, and therefore, they should not be construed to limit the technological concept disclosed herein by the accompanying drawings.

When an element such as a layer, region or substrate is referred to as being "on" another element, it can be directly on the another element or an intermediate element may also be interposed therebetween. A display device disclosed herein may include a portable phone, a smart phone, a laptop computer, a digital broadcast terminal, a personal digital assistant (PDA), a portable multimedia player (PMP), a navigation, a slate PC, a tablet PC, an ultrabook, a digital TV, a desktop computer, and the like. However, it would be easily understood by those skilled in the art that a configuration disclosed herein may be applicable to any displayable device even though it is a new product type which will be developed later.

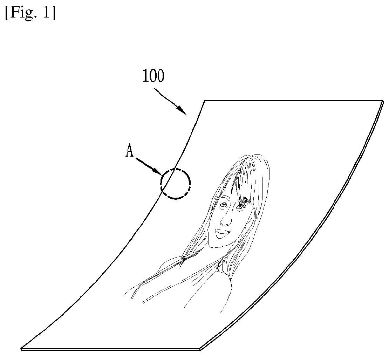

FIG. 1 is a conceptual view illustrating a display device using a semiconductor light emitting device according to an embodiment of a comparative example not forming part of the invention as claimed. According to the drawing, information processed in the controller of the display device 100 can be displayed using a flexible display.

The flexible display includes a flexible, bendable, twistable, foldable and rollable display. For example, the flexible display can be a display fabricated on a thin and flexible substrate that can be warped, bent, folded or rolled like a paper sheet while maintaining the display characteristics of a flat display in the related art.

A display area of the flexible display becomes a plane in a configuration that the flexible display is not warped (for example, a configuration having an infinite radius of curvature, hereinafter, referred to as a "first configuration"). The display area thereof becomes a curved surface in a configuration that the flexible display is warped by an external force in the first configuration (for example, a configuration having a finite radius of curvature, hereinafter, referred to as a "second configuration"). As illustrated in the drawing, information displayed in the second configuration may be visual information displayed on a curved surface. The visual information may be implemented by individually controlling the light emission of sub-pixels disposed in a matrix form. The sub-pixel denotes a minimum unit for implementing one color.

The sub-pixel of the flexible display may be implemented by a semiconductor light emitting device. According to the present disclosure, a light emitting diode (LED) is illustrated as a type of semiconductor light emitting device. The light emitting diode may be formed with a small size to perform the role of a sub-pixel even in the second configuration through this.

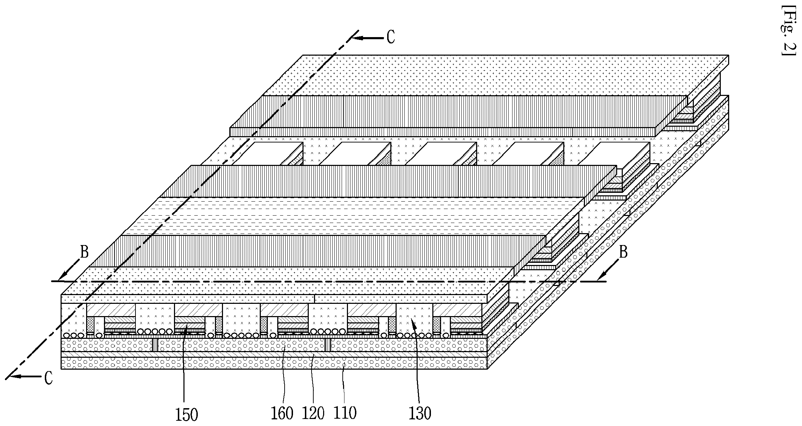

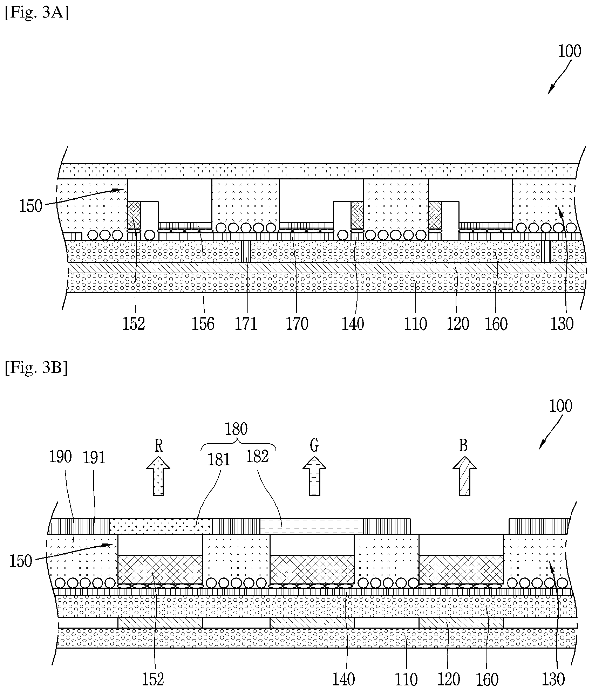

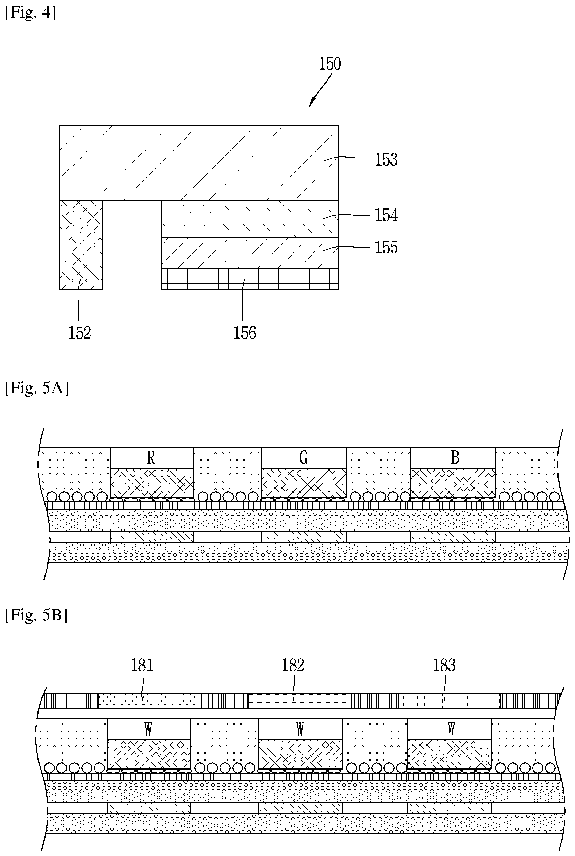

Hereinafter, a flexible display implemented using the light emitting diode will be described in more detail with reference to the accompanying drawings. In particular, FIG. 2 is a partial enlarged view of portion "A" in FIG. 1, FIGS. 3A and 3B are cross-sectional views taken along lines B-B and C-C in FIG. 2, FIG. 4 is a conceptual view illustrating a flip-chip type semiconductor light emitting device in FIG. 3A, and FIGS. 5A through 5C are conceptual views illustrating various forms for implementing colors in connection with a flip-chip type semiconductor light emitting device.

FIGS. 2, 3A and 3B illustrate a display device 100 using a passive matrix (PM) type semiconductor light emitting device as a display device 100 using a semiconductor light emitting device. However, the following illustration is also applicable to an active matrix (AM) type semiconductor light emitting device.

The display device 100 includes a substrate 110, a first electrode 120, a conductive adhesive layer 130, a second electrode 140, and a plurality of semiconductor light emitting devices 150. The substrate 110 may be a flexible substrate. The substrate 110 may contain glass or polyimide (PI) to implement the flexible display device. In addition, if it is a flexible material, any one such as polyethylene naphthalate (PEN), polyethylene terephthalate (PET) or the like may be used. Furthermore, the substrate 110 may be either one of transparent and non-transparent materials.

The substrate 110 may be a wiring substrate disposed with the first electrode 120, and thus the first electrode 120 may be placed on the substrate 110. According to the drawing, an insulating layer 160 is disposed on the substrate 110 placed with the first electrode 120, and an auxiliary electrode 170 is placed on the insulating layer 160. A configuration in which the insulating layer 160 is deposited on the substrate 110 may be a single wiring substrate. More specifically, the insulating layer 160 can be incorporated into the substrate 110 with an insulating and flexible material such as polyimide (PI), PET, PEN or the like to form single wiring substrate.

The auxiliary electrode 170 as an electrode for electrically connecting the first electrode 120 to the semiconductor light emitting device 150 is placed on the insulating layer 160, and disposed to correspond to the location of the first electrode 120. For example, the auxiliary electrode 170 has a dot shape, and can be electrically connected to the first electrode 120 by an electrode hole 171 passing through the insulating layer 160. The electrode hole 171 can be formed by filling a conductive material in a via hole.

Further, the conductive adhesive layer 130 can be formed on one surface of the insulating layer 160, but the comparative example is not limited to this. For example, it is possible to also have a structure in which the conductive adhesive layer 130 is disposed on the substrate 110 with no insulating layer 160. The conductive adhesive layer 130 performs the role of an insulating layer in the structure in which the conductive adhesive layer 130 is disposed on the substrate 110.

The conductive adhesive layer 130 can be a layer having adhesiveness and conductivity, and a conductive material and an adhesive material can be mixed on the conductive adhesive layer 130. Furthermore, the conductive adhesive layer 130 may have flexibility, thereby allowing a flexible function in the display device.

For example, the conductive adhesive layer 130 can be an anisotropic conductive film (ACF), an anisotropic conductive paste, a solution containing conductive particles, and the like. The conductive adhesive layer 130 allows electrical interconnection in the z-direction passing through the thickness thereof, but can be configured as a layer having electrical insulation in the horizontal x-y direction thereof. Accordingly, the conductive adhesive layer 130 can be referred to as a z-axis conductive layer (however, hereinafter referred to as a "conductive adhesive layer").

The anisotropic conductive film includes an anisotropic conductive medium mixed with an insulating base member, and thus when heat and pressure are applied thereto, only a specific portion thereof has conductivity by the anisotropic conductive medium. Hereinafter, heat and pressure are applied to the anisotropic conductive film, but other methods can be also available for the anisotropic conductive film to partially have conductivity. The methods also include applying only either one of heat and pressure thereto, UV curing, and the like.

Furthermore, the anisotropic conductive medium can be conductive balls or particles. In the present embodiment, the anisotropic conductive film includes an anisotropic conductive medium mixed with an insulating base member, and thus when heat and pressure are applied thereto, only a specific portion thereof has conductivity by the conductive balls. The anisotropic conductive film can include a core with a conductive material containing a plurality of particles coated by an insulating layer with a polymer material, and in this instance can have conductivity by the core while breaking an insulating layer on a portion to which heat and pressure are applied. Here, a core can be transformed to implement a layer having both surfaces to which objects contact in the thickness direction of the film.

In a more specific example, heat and pressure are applied to an anisotropic conductive film as a whole, and electrical connection in the z-axis direction is partially formed by a height difference from a mating object adhered by the use of the anisotropic conductive film. In another example, an anisotropic conductive film can include a plurality of particles in which a conductive material is coated on insulating cores. In this instance, a portion to which heat and pressure are applied can be converted (pressed and adhered) to a conductive material to have conductivity in the thickness direction of the film. In still another example, the film can be formed to have conductivity in the thickness direction of the film in which a conductive material passes through an insulating base member in the z-direction. In this instance, the conductive material may have a pointed end portion.

Further, the anisotropic conductive film can be a fixed array anisotropic conductive film (ACF) configured with a form in which conductive balls are inserted into one surface of the insulating base member. More specifically, the insulating base member is formed of an adhesive material, and the conductive balls are intensively disposed at a bottom portion of the insulating base member, and when heat and pressure are applied thereto, the base member is modified along with the conductive balls, thereby having conductivity in the vertical direction thereof.

However, the present comparative example is not limited to this, and the anisotropic conductive film can have a form in which conductive balls are randomly mixed with an insulating base member or a form configured with a plurality of layers in which conductive balls are disposed at any one layer (double-ACF), and the like.

The anisotropic conductive paste as a form coupled to a paste and conductive balls can be a paste in which conductive balls are mixed with an insulating and adhesive base material. Furthermore, a solution containing conductive particles can be a solution in a form containing conductive particles or nano particles.

Further, the second electrode 140 is located at the insulating layer 160 to be separated from the auxiliary electrode 170. In other words, the conductive adhesive layer 130 is disposed on the insulating layer 160 located with the auxiliary electrode 170 and the second electrode 140.

When the conductive adhesive layer 130 is formed in a state that the auxiliary electrode 170 and second electrode 140 are located, and then the semiconductor light emitting device 150 is connect thereto in a flip chip form with the application of heat and pressure, the semiconductor light emitting device 150 is electrically connected to the first electrode 120 and second electrode 140.

Referring to FIG. 4, the semiconductor light emitting device 150 may be a flip chip type semiconductor light emitting device. For example, the semiconductor light emitting device 150 can include a p-type electrode 156, a p-type semiconductor layer 155 formed with the p-type electrode 156, an active layer 154 formed on the p-type semiconductor layer 155, an n-type semiconductor layer 153 formed on the active layer 154, and an n-type electrode 152 disposed to be separated from the p-type electrode 156 in the horizontal direction on the n-type semiconductor layer 153. In this instance, the p-type electrode 156 can be electrically connected to the welding portion 179 by the conductive adhesive layer 130, and the n-type electrode 152 can be electrically connected to the second electrode 140.

Referring to FIGS. 2, 3A and 3B again, the auxiliary electrode 170 can be formed in an elongated manner in one direction to be electrically connected to a plurality of semiconductor light emitting devices 150. For example, the left and right p-type electrodes of the semiconductor light emitting devices around the auxiliary electrode can be electrically connected to one auxiliary electrode.

More specifically, the semiconductor light emitting device 150 is pressed into the conductive adhesive layer 130, and through this, only a portion between the p-type electrode 156 and auxiliary electrode 170 of the semiconductor light emitting device 150 and a portion between the n-type electrode 152 and second electrode 140 of the semiconductor light emitting device 150 have conductivity, and the remaining portion does not have conductivity since there is no push-down of the semiconductor light emitting device. Furthermore, a plurality of semiconductor light emitting devices 150 constitute a light-emitting array, and a phosphor layer 180 is formed on the light-emitting array.

The light emitting device may include a plurality of semiconductor light emitting devices with different self luminance values. Each of the semiconductor light emitting devices 150 constitutes a sub-pixel, and is electrically connected to the first electrode 120. For example, there may exist a plurality of first electrodes 120, and the semiconductor light emitting devices are arranged in several rows, for instance, and each row of the semiconductor light emitting devices can be electrically connected to any one of the plurality of first electrodes.

Furthermore, the semiconductor light emitting devices can be connected in a flip chip form, and thus semiconductor light emitting devices grown on a transparent dielectric substrate. In addition, the semiconductor light emitting devices can be nitride semiconductor light emitting devices, for instance. The semiconductor light emitting device 150 has an excellent luminance characteristic, and thus it is possible to configure individual sub-pixels even with a small size thereof.

Further, a partition wall 190 can be formed between the semiconductor light emitting devices 150. In this instance, the partition wall 190 divides individual sub-pixels from one another, and is formed as an integral body with the conductive adhesive layer 130. For example, a base member of the anisotropic conductive film can form the partition wall when the semiconductor light emitting device 150 is inserted into the anisotropic conductive film.

When the base member of the anisotropic conductive film is black, the partition wall 190 has reflective characteristics while at the same time increasing contrast with no additional black insulator. In another example, a reflective partition wall can be separately provided with the partition wall 190. In this instance, the partition wall 190 may include a black or white insulator according to the purpose of the display device. The wall enhances reflectivity when the partition wall of the while insulator is used, and increases contrast while at the same time having reflective characteristics.

The phosphor layer 180 can be located at an outer surface of the semiconductor light emitting device 150. For example, the semiconductor light emitting device 150 is a blue semiconductor light emitting device that emits blue (B) light, and the phosphor layer 180 performs the role of converting the blue (B) light into the color of a sub-pixel. The phosphor layer 180 can be a red phosphor layer 181 or green phosphor layer 182 constituting individual pixels.

In other words, a red phosphor 181 capable of converting blue light into red (R) light can be deposited on the blue semiconductor light emitting device 151 at a location implementing a red sub-pixel, and a green phosphor 182 capable of converting blue light into green (G) light can be deposited on the blue semiconductor light emitting device 151 at a location implementing a green sub-pixel. Furthermore, only the blue semiconductor light emitting device 151 can be solely used at a location implementing a blue sub-pixel. In this instance, the red (R), green (G) and blue (B) sub-pixels may implement one pixel. More specifically, one color phosphor can be deposited along each line of the first electrode 120. Accordingly, one line on the first electrode 120 can be an electrode controlling one color. In other words, red (R), green (B) and blue (B) can be sequentially disposed, thereby implementing sub-pixels.

However, the present comparative example is not limited to this, and the semiconductor light emitting device 150 can be combined with a quantum dot (QD) instead of a phosphor to implement sub-pixels such as red (R), green (G) and blue (B). Furthermore, a black matrix 191 can be disposed between each phosphor layer to enhance contrast. In other words, the black matrix 191 can enhance the contrast of luminance. However, the present disclosure is not limited to this, and another structure for implementing blue, red and green can be also applicable thereto.

Referring to FIG. 5A, each of the semiconductor light emitting devices 150 can be implemented with a high-power light emitting device that emits various lights including blue in which gallium nitride (GaN) is mostly used, and indium (In) and or aluminum (Al) are added thereto. In this instance, the semiconductor light emitting device 150 can be red, green and blue semiconductor light emitting devices, respectively, to implement each sub-pixel. For instance, red, green and blue semiconductor light emitting devices (R, G, B) are alternately disposed, and red, green and blue sub-pixels implement one pixel by the red, green and blue semiconductor light emitting devices, thereby implementing a full color display.

Referring to FIG. 5B, the semiconductor light emitting device may have a white light emitting device (W) provided with a yellow phosphor layer for each element. In this instance, a red phosphor layer 181, a green phosphor layer 182 and blue phosphor layer 183 can be provided on the white light emitting device (W) to implement a sub-pixel. Furthermore, a color filter repeated with red, green and blue on the white light emitting device (W) can be used to implement a sub-pixel.

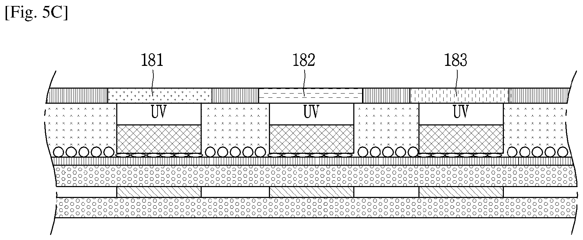

FIG. 5C illustrates a red phosphor layer 181, a green phosphor layer 182 and blue phosphor layer 183 provided on a ultra violet light emitting device (UV). Thus, the semiconductor light emitting device can be used over the entire region up to ultra violet (UV) as well as visible light, and can be extended to a form of semiconductor light emitting device in which ultra violet (UV) can be used as an excitation source.

Taking the present example into consideration again, the semiconductor light emitting device 150 is placed on the conductive adhesive layer 130 to configure a sub-pixel in the display device. The semiconductor light emitting device 150 has excellent luminance characteristics, and thus it is possible to configure individual sub-pixels even with a small size thereof. The size of the individual semiconductor light emitting device 150 may be less than 80 µm in the length of one side thereof, and formed with a rectangular or square shaped element. In case of a rectangular shaped element, the size thereof may be less than 20 x 80 µm.

Furthermore, even when a square shaped semiconductor light emitting device 150 with a length of side of 10 µm is used for a sub-pixel, it will exhibit a sufficient brightness for implementing a display device. Accordingly, for example, in case of a rectangular pixel in which one side of a sub-pixel is 600 µm in size, and the remaining one side thereof is 300 µm, a relative distance between the semiconductor light emitting devices becomes sufficiently large. Accordingly, it is possible to implement a flexible display device having a HD image quality.

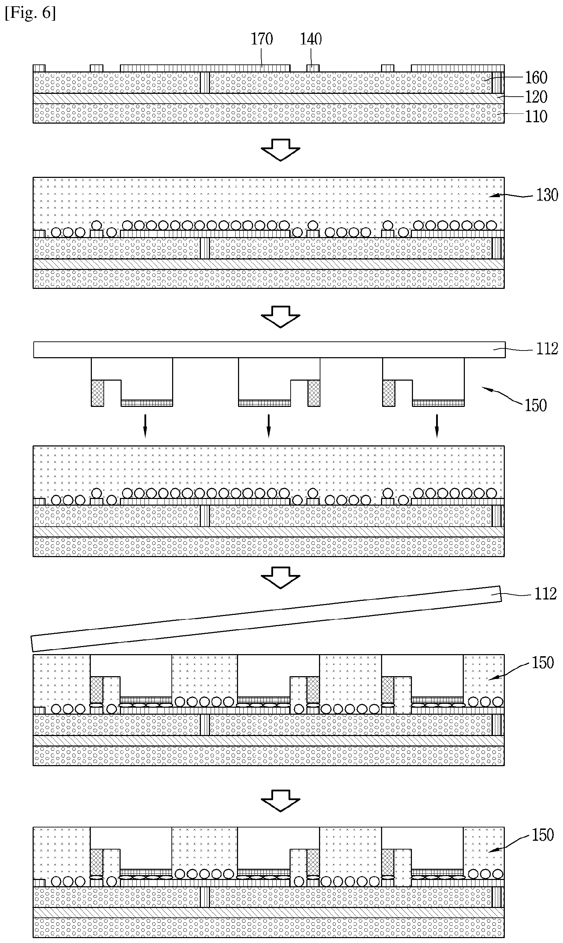

A display device using the foregoing semiconductor light emitting device is fabricated by a fabrication method. Hereinafter, the fabrication method will be described with reference to FIG. 6. In particular, FIG. 6 is cross-sectional views illustrating a method of fabricating a display device using a semiconductor light emitting device according to a comparative example not forming part of the invention as claimed.

As shown, first, the conductive adhesive layer 130 is formed on the insulating layer 160 located with the auxiliary electrode 170 and second electrode 140. The insulating layer 160 is deposited on the first substrate 110 to form one substrate (or wiring substrate), and the first electrode 120, auxiliary electrode 170 and second electrode 140 are disposed at the wiring substrate. In this instance, the first electrode 120 and second electrode 140 can be disposed in a perpendicular direction to each other. Furthermore, the first substrate 110 and insulating layer 160 may contain glass or polyimide (PI), respectively, to implement a flexible display device.

The conductive adhesive layer 130 can be implemented by an anisotropic conductive film, for example, and the anisotropic conductive film can be coated on a substrate located with the insulating layer 160. Next, a second substrate 112 located with a plurality of semiconductor light emitting devices 150 corresponding to the location of the auxiliary electrodes 170 and second electrodes 140 and constituting individual pixels is disposed such that the semiconductor light emitting device 150 faces the auxiliary electrode 170 and second electrode 140.

In this instance, the second substrate 112 as a growth substrate for growing the semiconductor light emitting device 150 may be a sapphire substrate or silicon substrate. The semiconductor light emitting device may have a gap and size capable of implementing a display device when formed in the unit of wafer, and thus effectively used for a display device.

Next, the wiring substrate is thermally compressed to the second substrate 112. For example, the wiring substrate and second substrate 112 can be thermally compressed to each other by applying an ACF press head. The wiring substrate and second substrate 112 are bonded to each other using the thermal compression. Only a portion between the semiconductor light emitting device 150 and the auxiliary electrode 170 and second electrode 140 may have conductivity due to the characteristics of an anisotropic conductive film having conductivity by thermal compression, thereby allowing the electrodes and semiconductor light emitting device 150 to be electrically connected to each other. In addition, the semiconductor light emitting device 150 can be inserted into the anisotropic conductive film, thereby forming a partition wall between the semiconductor light emitting devices 150.

Next, the second substrate 112 is removed. For example, the second substrate 112 can be removed using a laser lift-off (LLO) or chemical lift-off (CLO) method. Finally, the second substrate 112 is removed to expose the semiconductor light emitting devices 150 to the outside. Silicon oxide (SiOx) or the like can be coated on the wiring substrate coupled to the semiconductor light emitting device 150 to form a transparent insulating layer.

The process of forming a phosphor layer on one surface of the semiconductor light emitting device 150 can also be included. For example, the semiconductor light emitting device 150 can be a blue semiconductor light emitting device for emitting blue (B) light, and red or green phosphor for converting the blue (B) light into the color of the sub-pixel may form a layer on one surface of the blue semiconductor light emitting device.

The fabrication method or structure of a display device using the foregoing semiconductor light emitting device can be modified in various forms. For example, the foregoing display device can be applicable to a vertical semiconductor light emitting device. Hereinafter, the vertical structure will be described with reference to FIGS. 5 and 6.

In addition, according to the following modified example or embodiment, the same or similar reference numerals are designated to the same or similar configurations to the foregoing example, and the description thereof will be substituted by the earlier description.

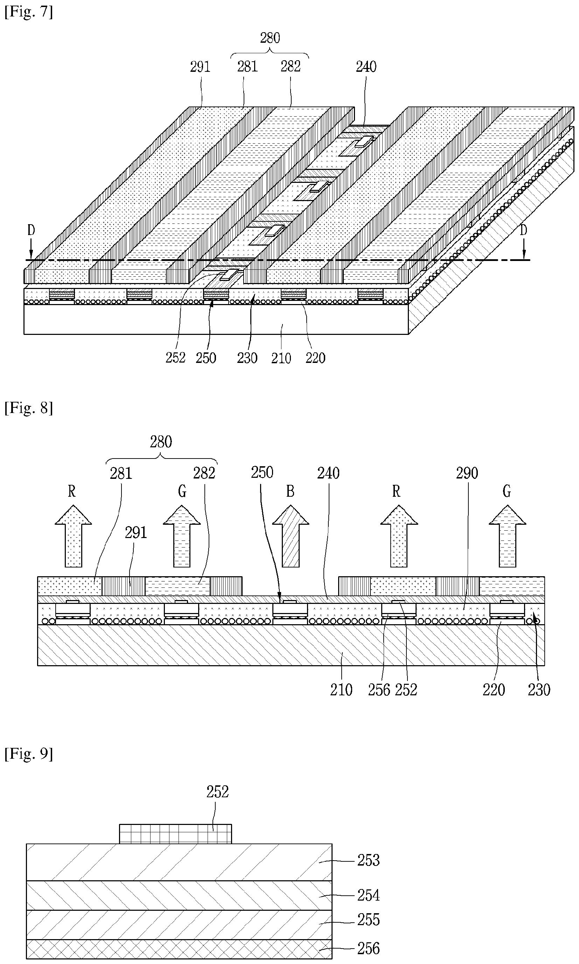

FIG. 7 is a perspective view illustrating a display device using a semiconductor light emitting device according to another comparative example not forming part of the invention as claimed. In addition, FIG. 8 is a cross-sectional view taken along line C-C in FIG. 7, and FIG. 9 is a conceptual view illustrating a vertical type semiconductor light emitting device in FIG. 8. Further, the display device can use a passive matrix (PM) type of vertical semiconductor light emitting device.

The display device includes a substrate 210, a first electrode 220, a conductive adhesive layer 230, a second electrode 240 and a plurality of semiconductor light emitting devices 250. The substrate 210 as a wiring substrate disposed with the first electrode 220 may include polyimide (PI) to implement a flexible display device. In addition, any one can be used if it is an insulating and flexible material.

The first electrode 220 is located on the substrate 210, and formed with a bar-shaped electrode elongated in one direction. The first electrode 220 can also be formed to perform the role of a data electrode. The conductive adhesive layer 230 is formed on the substrate 210 located with the first electrode 220. Similarly to a display device to which a flip chip type light emitting device is applied, the conductive adhesive layer 230 can be an anisotropic conductive film (ACF), an anisotropic conductive paste, a solution containing conductive particles, and the like. However, the present embodiment illustrates the conductive adhesive layer 230 being implemented by an anisotropic conductive film.

When an anisotropic conductive film is located in a state that the first electrode 220 is located on the substrate 210, and then heat and pressure are applied to connect the semiconductor light emitting device 250 thereto, the semiconductor light emitting device 250 is electrically connected to the first electrode 220. In addition, the semiconductor light emitting device 250 can be preferably disposed on the first electrode 220.

The electrical connection is generated because an anisotropic conductive film partially has conductivity in the thickness direction when heat and pressure are applied as described above. Accordingly, the anisotropic conductive film is partitioned into a portion having conductivity and a portion having no conductivity in the thickness direction thereof. Furthermore, the anisotropic conductive film contains an adhesive component, and thus the conductive adhesive layer 230 implements a mechanical coupling as well as an electrical coupling between the semiconductor light emitting device 250 and the first electrode 220.

Thus, the semiconductor light emitting device 250 is placed on the conductive adhesive layer 230, thereby configuring a separate sub-pixel in the display device. The semiconductor light emitting device 250 has excellent luminance characteristics, and thus it is possible to configure individual sub-pixels even with a small size thereof. The size of the individual semiconductor light emitting device 250 can be less than 80 µm in the length of one side thereof, and formed with a rectangular or square shaped element. In case of a rectangular shaped element, the size thereof can be less than 20 x 80 µm. The semiconductor light emitting device 250 can be a vertical structure.

A plurality of second electrodes 240 disposed in a direction of crossing the length direction of the first electrode 220, and electrically connected to the vertical semiconductor light emitting device 250 can be located between vertical semiconductor light emitting devices.

Referring to FIG. 9, the vertical semiconductor light emitting device includes a p-type electrode 256, a p-type semiconductor layer 255 formed with the p-type electrode 256, an active layer 254 formed on the p-type semiconductor layer 255, an n-type semiconductor layer 253 formed on the active layer 254, and an n-type electrode 252 formed on the n-type semiconductor layer 253. In this instance, the p-type electrode 256 located at the bottom thereof is electrically connected to the first electrode 220 by the conductive adhesive layer 230, and the n-type electrode 252 located at the top thereof is electrically connected to the second electrode 240 which will be described later. The electrodes can be disposed in the upward/downward direction in the vertical semiconductor light emitting device 250, thereby providing a great advantage capable of reducing the chip size.

Referring to FIG. 8 again, a phosphor layer 280 is formed on one surface of the semiconductor light emitting device 250. For example, the semiconductor light emitting device 250 is a blue semiconductor light emitting device 251 that emits blue (B) light, and the phosphor layer 280 for converting the blue (B) light into the color of the sub-pixel can be provided thereon. In this instance, the phosphor layer 280 can be a red phosphor 281 and a green phosphor 282 constituting individual pixels.

In other words, a red phosphor 281 capable of converting blue light into red (R) light can be deposited on the blue semiconductor light emitting device 251 at a location implementing a red sub-pixel, and a green phosphor 282 capable of converting blue light into green (G) light can be deposited on the blue semiconductor light emitting device 251 at a location implementing a green sub-pixel. Furthermore, only the blue semiconductor light emitting device 251 can be solely used at a location implementing a blue sub-pixel. In this instance, the red (R), green (G) and blue (B) sub-pixels may implement one pixel.

However, the present comparative example is not limited to this, and another structure for implementing blue, red and green can be also applicable thereto as described above in a display device to which a flip chip type light emitting device is applied. In addition, the second electrode 240 is located between the semiconductor light emitting devices 250, and electrically connected to the semiconductor light emitting devices 250. For example, the semiconductor light emitting devices 250 can be disposed in a plurality of rows, and the second electrode 240 can be located between the rows of the semiconductor light emitting devices 250.

Since a distance between the semiconductor light emitting devices 250 constituting individual pixels is sufficiently large, the second electrode 240 can be located between the semiconductor light emitting devices 250. The second electrode 240 can be formed with a bar-shaped electrode elongated in one direction, and disposed in a perpendicular direction to the first electrode.

Furthermore, the second electrode 240 is electrically connected to the semiconductor light emitting device 250 by a connecting electrode protruded from the second electrode 240. More specifically, the connecting electrode can be an n-type electrode of the semiconductor light emitting device 250. For example, the n-type electrode is formed with an ohmic electrode for ohmic contact, and the second electrode covers at least part of the ohmic electrode by printing or deposition. Through this, the second electrode 240 can be electrically connected to the n-type electrode of the semiconductor light emitting device 250.

Further, the second electrode 240 is located on the conductive adhesive layer 230. In addition, a transparent insulating layer containing silicon oxide (SiOx) can be formed on the substrate 210 formed with the semiconductor light emitting device 250. When the transparent insulating layer is formed and then the second electrode 240 is placed thereon, the second electrode 240 can be located on the transparent insulating layer. Furthermore, the second electrode 240 can be formed to be separated from the conductive adhesive layer 230 or transparent insulating layer.

If a transparent electrode such as indium tin oxide (ITO) is used to locate the second electrode 240 on the semiconductor light emitting device 250, the ITO material has a problem of bad adhesiveness with an n-type semiconductor. Accordingly, the second electrode 240 can be placed between the semiconductor light emitting devices 250, thereby obtaining an advantage in which the transparent electrode is not required. Accordingly, an n-type semiconductor layer and a conductive material having a good adhesiveness can be used as a horizontal electrode without being restricted by the selection of a transparent material, thereby enhancing the light extraction efficiency.

Further, a partition wall 290 can be formed between the semiconductor light emitting devices 250. In other words, the partition wall 290 can be disposed between the vertical semiconductor light emitting devices 250 to isolate the semiconductor light emitting device 250 constituting individual pixels. In this instance, the partition wall 290 may perform the role of dividing individual sub-pixels from one another, and be formed as an integral body with the conductive adhesive layer 230. For example, a base member of the anisotropic conductive film may form the partition wall when the semiconductor light emitting device 250 is inserted into the anisotropic conductive film.

In addition, when the base member of the anisotropic conductive film is black, the partition wall 290 has reflective characteristics while at the same time increasing contrast with no additional black insulator. In another example, a reflective partition wall can be separately provided with the partition wall 290. In this instance, the partition wall 290 may include a black or white insulator according to the purpose of the display device.

If the second electrode 240 is precisely located on the conductive adhesive layer 230 between the semiconductor light emitting devices 250, the partition wall 290 can be located between the semiconductor light emitting device 250 and second electrode 240. Accordingly, individual sub-pixels can be configured even with a small size using the semiconductor light emitting device 250, and a distance between the semiconductor light emitting devices 250 can be relatively sufficiently large to place the second electrode 240 between the semiconductor light emitting devices 250, thereby having the effect of implementing a flexible display device having a HD image quality.

Further, a black matrix 291 can be disposed between each phosphor layer to enhance contrast. In other words, the black matrix 191 can enhance the contrast of luminance. As described above, the semiconductor light emitting device 250 is located on the conductive adhesive layer 230, thereby constituting individual pixels on the display device. Since the semiconductor light emitting device 250 has excellent luminance characteristics, thereby configuring individual sub-pixels even with a small size thereof. As a result, it is possible to implement a full color display in which the sub-pixels of red (R), green (G) and blue (B) implement one pixel by means of the semiconductor light emitting device.

Further, in a display device having a semiconductor light emitting device, there may exist defects in at least some of the semiconductor light emitting devices. Such a defective semiconductor light emitting device can be referred to as a NG cell, and the present disclosure provides a semiconductor light emitting device structure having a novel structure for more easily replacing a semiconductor light emitting device corresponding to a NG cell, and a display device having the same.

In particular, according to the present disclosure, an extra space in which a plurality of light emitting portions and a semiconductor light emitting device can be additionally disposed is arranged in one sub-pixel portion. Furthermore, a redundancy repair method in which an NG cell corresponding to a defective light emitting portion is disconnected to drive only the remaining light emitting portions included in the sub-pixel portion is provided.

Here, the light emitting portion may denote one semiconductor light emitting device. According to the present invention, one semiconductor light emitting device shares a conductive semiconductor layer with another semiconductor light emitting device, which will be described in more detail below.

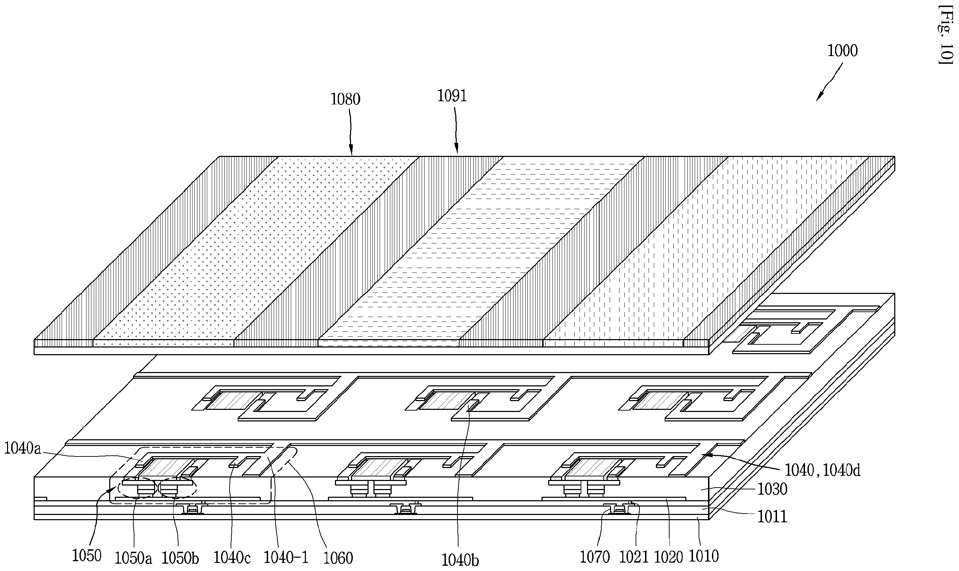

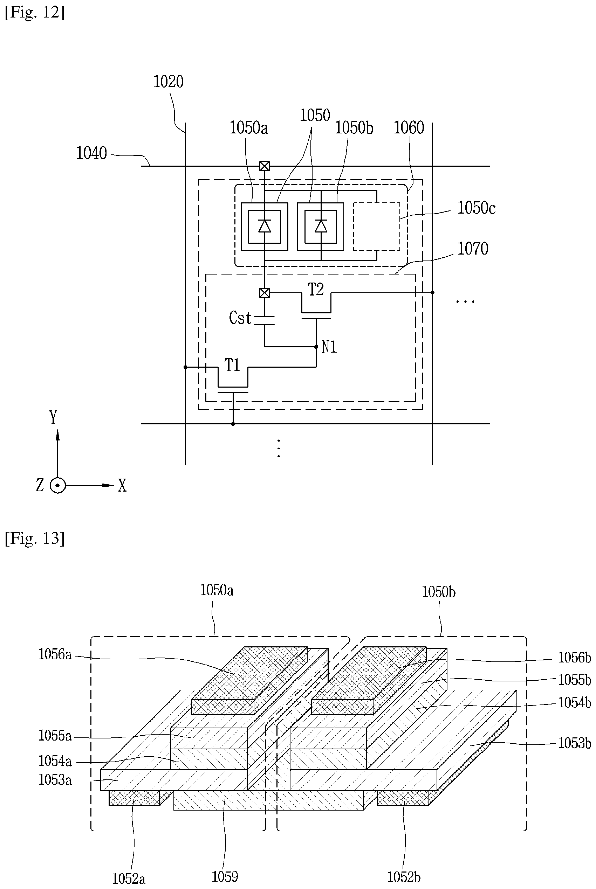

Hereinafter, a display device to which the redundancy repair method is applied will be described in detail with reference to the accompanying drawings. In particular, FIGS. 10-12 are enlarged views illustrating a portion A in FIG. 1 illustrating an embodiment according to the invention to which the semiconductor light emitting device having a novel structure according to the present disclosure is applied. FIGS. 13-15 are conceptual views illustrating a semiconductor light emitting device according to the present invention.

FIGS. 10-12 illustrate a display device 1000 using an active matrix (AM) type semiconductor light emitting device is illustrated. However, an example described below can also be applicable to a passive matrix (PM) type semiconductor light emitting device.

The display device 1000 includes a plurality of semiconductor light emitting devices 1050 on a substrate 1010 and a sub-pixel portion 1060. The substrate 1010 is a thin film transistor array substrate, and can be made of a glass or a plastic material. The substrate 1010 includes a first and a second electrode portion 1020, 1040 for supplying power to the sub-pixel portion 1060.

Furthermore, the substrate 1010 includes a driving portion 1070 for controlling power supply and data signal transmission to the sub-pixel portion 1060, and the driving portion 1070 is electrically connected to the sub-pixel portion 1060 through the first and the second electrode portion 1020, 1040. The driving portion 1070 can be a driving thin film transistor, and can be various types of switching devices. In the drawing according to the present specification, the driving portion 1070 is schematically shown, and one driving portion 1070 can supply driving power to one sub-pixel portion 1060 to perform control in the unit of the sub-pixel portion 1060.

A plurality of gate lines (GLs), a plurality of data lines (DLs), a plurality of driving power lines (PLs), and a plurality of common power lines (CLs) can be disposed on the substrate 1010 for electrical connection between the driving portion 1070 and the sub-pixel portion 1060 and supplying driving power thereto, and the detailed description thereof is omitted.

Further, the first electrode portion 1020 can be configured to perform the role of a common electrode and a common power line, and the second electrode portion 1040 can be configured to perform the role of a data electrode and a data line (DL). They can also be configured to perform opposite roles.

In addition, the sub-pixel portion 1060 is a minimum unit region in which light is actually emitted, is formed to emit light of the same color, and is formed to have a first and a second light emitting portion 1050a, 1050b spaced apart with a groove therebetween. At least three sub-pixel portions adjacent to one another may constitute one unit pixel (or unit picture element) for color display. For example, one unit pixel may include a red sub-pixel portion, a green sub-pixel portion, and a blue sub-pixel portion adjacent to one another, and may further include a white pixel for luminance enhancement.

Moreover, a phosphor layer 1080 can be located on an outer surface of the sub-pixel portion 1060. For example, a light emitting portion, that is, semiconductor light emitting device, included in the sub-pixel portion 1060 is a blue semiconductor light emitting device that emits blue (B) light, and the phosphor layer 1080 performs a function of converting the blue(B) light into a color of the pixel. The phosphor layer 1080 can be a red phosphor 1081 or a green phosphor 1082 constituting an individual pixel.

In other words, a red phosphor 1081 capable of converting blue light into red (R) light can be deposited on a first sub-pixel portion at a position forming a red unit pixel, and a green phosphor 1082 capable of converting blue light into green (G) light can be deposited on a second sub-pixel portion adjacent to the first sub-pixel portion at a position forming a green unit pixel. In addition, only a blue semiconductor light emitting device can be used solely in a portion constituting a blue unit pixel. The red (R), green (G) and blue (B) sub-pixel portions can form one pixel.

More specifically, as illustrated in FIG. 10, one color of phosphor can be deposited along the column direction. In this instance, a phosphor layer of the same color is coated on one sub-pixel portion 1060, and therefore, the phosphors of the same material can be deposited on the light emitting portions provided in the sub-pixel portion, the first and second light emitting portions, to convert light output from the first and second light emitting portions into the same color.

Moreover, as illustrated in the drawings, the phosphor layer may also be formed to be deposited in the repair site 1050c. However, the present disclosure is not limited thereto, and instead of the phosphors, the semiconductor light emitting device 1050 and the quantum dot (QD) can be combined to form red (R), green (G) and blue (B) unit pixels.

In addition, a black matrix 1091 can be disposed between each of the phosphor layers in order to enhance contrast. In other words, the black matrix 1091 can enhance the contrast of light and dark. However, the present disclosure is not limited thereto, and other structures for implementing blue, red and green may also be applied thereto.

Hereinafter, the sub-pixel portion 1060 according to the present invention will be described in more detail. As described above, the sub-pixel portion 1060 includes an empty space (or a repair site) 1050c in which 1050a, 1050b and an additional light emitting portion (or semiconductor light emitting device) can be disposed.

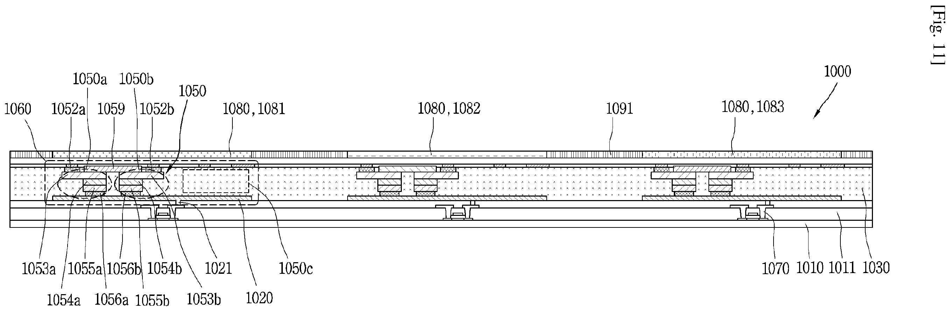

FIGS. 11-13 illustrate the sub-pixel portion 1060 includes two light emitting portions 1050a, 1050b, but the present disclosure is not limited thereto, and a larger number of light emitting portions can be provided in the sub-pixel portion 1060. The light emitting portion may also be referred to as a semiconductor light emitting device.

The sub-pixel portion according to the present embodiment is configured to have an undoped semiconductor layer 1059, and the first and the second light emitting portion 1050a, 1050b are respectively formed to be deposited on the undoped semiconductor layer 1059 with a groove therebetween. In other words, the first and the second light emitting portion 1050a, 1050b can be spaced apart from each other on the undoped semiconductor layer 1059.

Further, the second electrode portion 1040 or wiring electrode includes a base electrode 1040-1 for transmitting the same electric signal to the first and the second light emitting portion 1050a, 1050b, a first sub-electrode 1040a extended from the base electrode 1040-1 and electrically connected to the first light emitting portion 1050a, and a second sub-electrode 1040b extended from the base electrode 1040-1 and electrically connected to the second light emitting portion 1050b.

Moreover, the wiring electrode (or second electrode portion 1040) may further include a third sub-electrode 1040c extended from the base electrode 1040-1 toward the repair site 1050c. The sub-electrodes provided on the wiring electrode can be provided in proportion to a number of the light emitting portions and a number of the repair sites provided in the sub-pixel portion.

The same data signal is transmitted to the first through third sub-electrodes 1040a, 1040b, 1040c, respectively, and the light emitting portions provided in the sub-pixel portion 1060 can emit light based on the same data signal. Further, the first and the second sub-electrode 1040a, 1040b are extended from the base electrode 1040-1 and electrically connected to the respective light emitting portions, and in particular, electrically connected to an electrode provided on a specific conductive semiconductor layer provided in each light emitting portion.

The light emitting portion provided in the sub-pixel portion can have various structures, and as illustrated in FIG. 13, the first and the second light emitting portion 1050a, 1050b deposited on the undoped semiconductor layer 1059 respectively include a first and a second conductive semiconductor layer 1053a, 1053b, 1055a, 1055b, and an active layer 1054a,1054b formed between the first and the second conductive semiconductor layer 1053a, 1053b, 1055a, 1055b. Moreover, a first conductive electrode 1052a,1052b is formed on one surface of the first conductive semiconductor layer 1053a,1053b, and a second conductive electrode 1056a, 1056b is formed on one surface of the second conductive semiconductor layer 1055a, 1055b.

The undoped semiconductor layer 1059 can be formed on one surface of the first conductive semiconductor layer 1053a, 1053b, and the active layer 1054a, 1054b can be etched on the other surface thereof. Further, the first conductive electrode 1052a, 1052b can be formed on at least part of the first conductive semiconductor layer 1053a, 1053b on which the undoped semiconductor layer 1059 is formed. In other words, the undoped semiconductor layer 1059 may not be formed to cover the first conductive semiconductor layers 1053a, 1053b as a whole, but formed to cover only part thereof.

Also, the first conductive electrode 1052a, 1052b and the first conductive semiconductor layer 1053a, 1053b can be an n-type electrode and an n-type semiconductor layer, respectively, and the second conductive electrode 1056a, 1056b and the second conductive semiconductor layers 1055a, 1055b can be a p-type electrode and a p-type semiconductor layer, respectively. However, the present disclosure is not limited thereto, and the first conductive electrode and the first conductive semiconductor layer can be a p-type electrode and the second conductive electrode and the second conductive semiconductor layer can be an n-type electrode.

In addition, the first conductive electrode 1052a, 1052b of the first and the second light emitting portion 1050a, 1050b can be disposed on both sides with the undoped semiconductor layer 1059 at the center, as illustrated in the drawing.

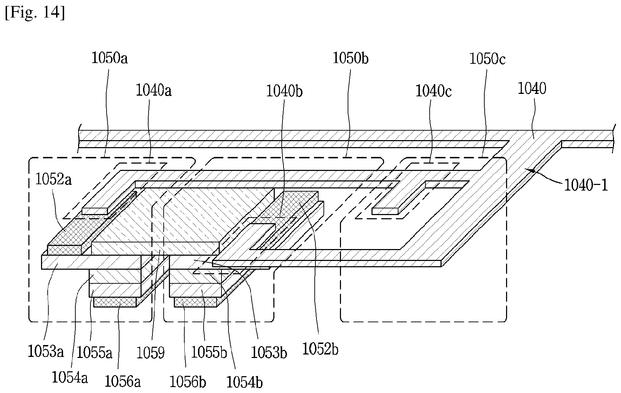

As illustrated in FIG. 14, the first conductive electrode 1053a included in the first light emitting portion 1050a is electrically connected to the first sub-electrode 1040a, and the first conductive electrode 1053b included in the second light emitting portion 1050b can be electrically connected to the second sub-electrode 1040b. Further, FIG. 14 illustrates a view in which the light emitting portion (or the semiconductor light emitting device) is not additionally disposed in the repair site 1050c. However, when the light emitting portion is additionally provided in the repair site 1050c, the additionally provided light emitting portion and the third sub-electrode 1040c can be electrically connected to each other.

Further, as described above, a plurality of light emitting portions 1050a, 1050b included in the same sub-pixel portion 1060 are configured to emit light based on a signal transmitted through a plurality of sub-electrodes 1040a, 1040b that are branched from the base electrode 1040d. As illustrated in FIG. 14, the first conductive electrode 1052a included in the first light emitting portion 1050a can be electrically connected to the first sub-electrode 1040a, and the second conductive electrode 1052b included in the second light emitting portion 1050b can be electrically connected to the second sub-electrode 1040b.

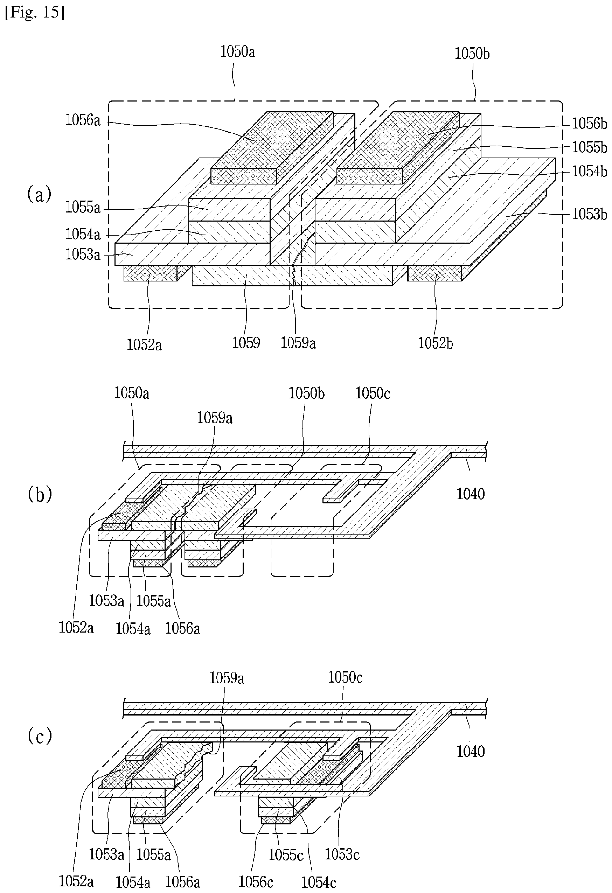

As illustrated in FIG. 15, in order to remove a light emitting portion corresponding to an NG cell, a laser is irradiated to the undoped semiconductor layer 1059 to allow the first and the second light emitting portion 1050a, 1050b to be physically separated. Further, laser ablation is used, and through this, a crack can be formed on a cross-section 1059a of the undoped semiconductor layer 1059 irradiated with the laser as illustrated in FIGS. 15(a), 15(b) and 15(c).

When there is a light emitting portion corresponding to an NG cell, the undoped semiconductor layer 1059 can be cracked using laser ablation as illustrated in FIG. 15(b), and then the light emitting portion corresponding to the NG cell (for example, the second light emitting portion 1050b including even an undoped semiconductor layer deposited on the second light emitting portion 1050b) can be removed as illustrated in FIG. 15(c).

Then, as illustrated in FIG. 15(c), a new semiconductor light emitting device can be inserted into the repair site 1050c. Thus, the sub-pixel portion 1060 can be provided with at least two light emitting portions that are free from defects to emit light of the same brightness as that of the other sub-pixel portions 1060.

Further, in the above description, an example of removing a defective light emitting portion has been described, but according to the present disclosure, it may also be possible to insert a new semiconductor light emitting device into the repair site while maintaining the defective light emitting portion without removing it.

According to the present invention having the foregoing configuration, a plurality of semiconductor light emitting devices that share at least one semiconductor layer can be included in one unit cell (sub-pixel portion). In other words, the unit cell can be provided with a plurality of semiconductor light emitting devices that share one semiconductor layer other than a plurality of physically separated semiconductor light emitting devices, thereby reducing the complexity of the process of transferring them to a substrate.

In addition, an empty space can be provided in the unit cell, and a new semiconductor light emitting device can be disposed in the empty space provided in the unit cell including a defective semiconductor light emitting device. Therefore, even when a defective semiconductor light emitting device is included in the unit cell, the display device according to the present disclosure can additionally arrange a semiconductor light emitting device that can replace the semiconductor light emitting device, thereby facilitating the replacement of the defective semiconductor light emitting device.

In addition, a plurality of semiconductor light emitting devices included in the unit cell and sub-electrodes branched respectively into empty spaces can be provided to remove a defective semiconductor light emitting device or not to perform additional wiring even when a new semiconductor light emitting device is disposed in an empty space, thereby more conveniently removing and replacing the semiconductor light emitting device.

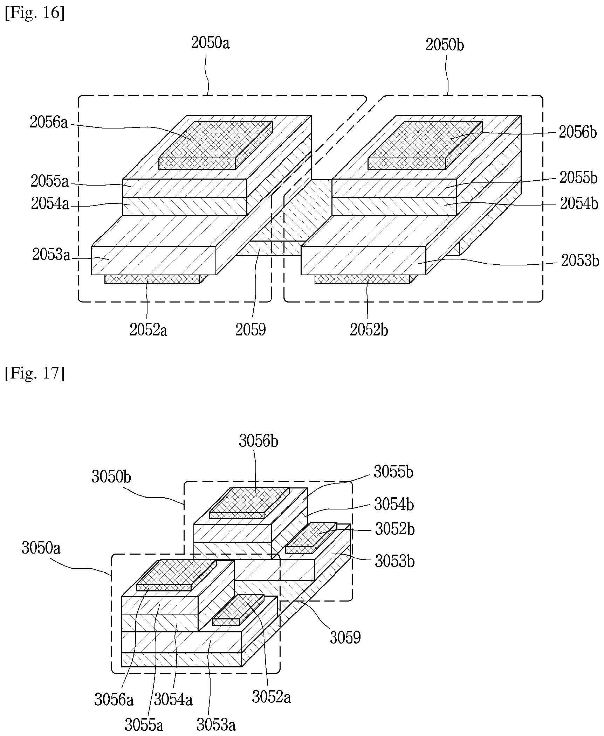

Also, light emitting portions, that is, a semiconductor light emitting device, provided in the sub-pixel portion can be modified into various structures, and examples thereof will be described in detail with reference to the accompanying drawings. In particular, FIGS. 16 and 17 are conceptual views illustrating the semiconductor light emitting device of another example according to the invention.

For example, as illustrated in FIG. 16, a first and a second light emitting portion 2050a, 2050b can be deposited on an undoped semiconductor layer 2059, and may include first conductive semiconductor layers 2053a, 2053b spaced apart from each other, active layers 2054a, 2054b etched on the first conductive semiconductor layers 2053a, 2053b, and second conductive semiconductor layers 2055a, 2055b deposited on the active layers.

The first conductive semiconductor layers, the active layers and the second conductive semiconductor layers 2053a, 2053b, 2054a, 2054b, 2055a, 2055b are spaced apart from each other with a groove therebetween on an undoped semiconductor layer 2059. The undoped semiconductor layer 2059 can be formed on one side of the first conductive semiconductor layers 2053a, 2053b. In addition, first conductive electrodes 2052a, 2052b can be formed on the other side of the first conductive semiconductor layers 2053a, 2053b, respectively.

Moreover, second conductive electrodes 2056a, 2056b are formed on one surface of the second conductive semiconductor layers 2055a, 2055b. Further, the undoped semiconductor layer 2059 can be formed on one surface of the first conductive semiconductor layers 2053a, 2053b and the active layers 2054a, 2054b can be etched on the other surface thereof.

In addition, the first conductive electrodes 2052a, 2052b can be respectively formed on the other side opposite to one side of the first conductive semiconductor layers 2053a, 2053b on which the undoped semiconductor layer 2059 is formed. In other words, the undoped semiconductor layer 2059 may not be formed to entirely cover the first conductive semiconductor layers 2053a, 2053b, but can be formed to cover only part thereof.

As described above, the undoped semiconductor layer 2059 and the first conductive electrodes 2052a, 2052b can be formed on one surface of the first conductive semiconductor layers 2053a, 2053b, and the active layers 2054a, 2054b can be deposited on the other surface thereof.

Also, the first conductive electrodes 2052a, 2052b and the first conductive semiconductor layers 2053a, 2053b can be n-type electrodes and n-type semiconductor layers, respectively, and the second conductive electrodes 2056a, 2056b and the second conductive semiconductor layers 2055a, 2055b can be p-type electrodes and p-type semiconductor layers, respectively. However, the present disclosure is not limited thereto, and the first conductive electrodes and first conductive semiconductor layers can be p-type electrodes and the second conductive electrodes and second conductive semiconductor layers can be n-type electrodes. Further, the first conductive electrodes 2052a, 2052b can be electrically connected to the sub-electrodes provided in the second electrode portion 1040 (refer to FIG. 10).

In another example, as illustrated in FIG. 17, a first and a second light emitting portion 3050a, 3050b can be deposited on an undoped semiconductor layer 3059, and can include a first conductive semiconductor layers 3053a, 3053b spaced apart from each other, active layers 3054a, 3054b deposited on the first conductive semiconductor layers 3053a, 3053b, and second conductive semiconductor layers 3055a, 3055b deposited on the active layers.

The first conductive semiconductor layer, the active layers and the second conductive semiconductor layers 3053a, 3053b, 3054a, 3054b, 3055a, 3055b are spaced apart from each other with a groove therebetween on the undoped semiconductor layer 3059. Also, the undoped semiconductor layer 3059 can be formed on one surface of the first conductive semiconductor layers 3053a and 3053b, and the active layers 3054a, 3054b and the first conductive electrodes 3052a, 3052b can be formed on the other surface thereof.

In addition, second conductive electrodes 3056a, 3056b are formed on one surface of the second conductive semiconductor layers 3055a, 3055b. Further, a first and a second conductive electrode 3052a, 3056a of the first light emitting portion 3050a can be spaced apart in a horizontal direction, and similarly, a first and a second conductive electrode 3052b, 3066b of the second light emitting portion 3050b may also be spaced apart in a horizontal direction.

Furthermore, the first conductive electrodes 3052a, 3052b and the first conductive semiconductor layers 3053a, 3053b can be n-type electrodes and n-type semiconductor layers, respectively, and the second conductive electrodes 3056a, 3056b and the second conductive semiconductor layers 3055a, 3055b can be p-type electrodes and p-type semiconductor layers, respectively. However, the present disclosure is not limited thereto, and the first conductive electrodes and first conductive semiconductor layers can be p-type electrodes and the second conductive electrodes and second conductive semiconductor layers can be n-type electrodes. Also, the first conductive electrodes 3052a, 3052b can be electrically connected to the sub-electrodes provided in the second electrode portion 1040 (refer to FIG. 10) as described above.

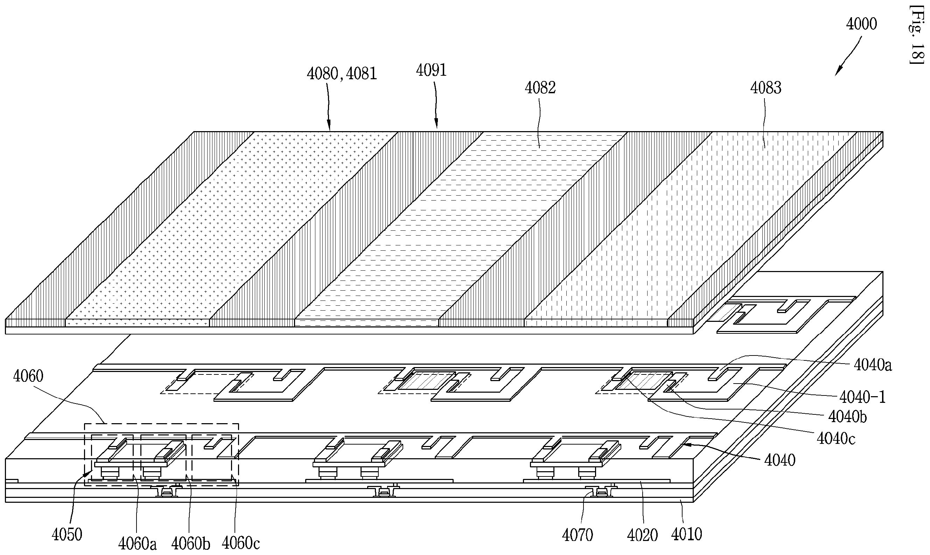

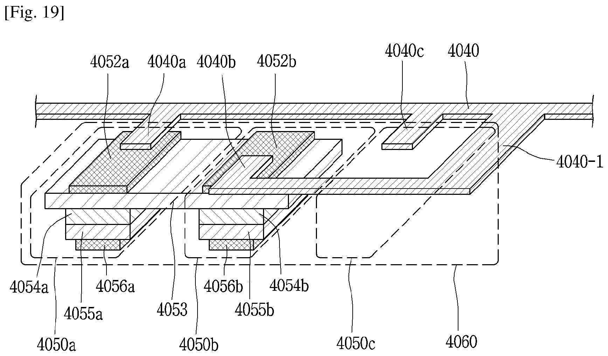

In addition, according to the above embodiments, light emitting portions that share an undoped semiconductor layer have been described. The display device according to the present disclosure includes a plurality of light emitting portions that share a single conductive semiconductor layer, and hereinafter, the present disclosure will be described in detail with reference to the accompanying drawings. FIGS. 18 and 19 are enlarged views illustrating a portion A in FIG. 1 illustrating another embodiment of the present invention to which a semiconductor light emitting device having a novel structure according to another embodiment of the present invention is applied.

Referring to FIGS. 18 and 19, a display device 4000 using an active matrix (AM) type semiconductor light emitting device as a display device 1000 using a semiconductor light emitting device is illustrated. However, an example described below may also be applicable to a passive matrix (PM) semiconductor light emitting device.

The display device 4000 includes a substrate 4010, a sub-pixel portion 4060, and a plurality of semiconductor light emitting devices 4050 that form the sub-pixel portion 4060. The substrate 4010 is a thin film transistor array substrate, and can be made of glass or a plastic material. The substrate 4010 includes a first and a second electrode portion 4020, 4040 for supplying power to the sub-pixel portion 4060.

Furthermore, the substrate 4010 is provided with a driving portion 4070 for controlling power supply and data signal transmission to the sub-pixel portion 4060, and the driving portion 4070 is formed to be electrically connected to the sub-pixel portion 4060 through the first and the second electrode portion 4020, 4040. The driving portion 4070 can be a driving thin film transistor, and besides, can be various types of switching devices. In the drawing according to the present specification, the driving portion 4070 is schematically shown, and one driving portion 4070 may supply driving power to one sub-pixel portion 4060 to perform control in the unit of the sub-pixel portion 4060.

A plurality of gate lines (GLs), a plurality of data lines (DLs), a plurality of driving power lines (PLs), and a plurality of common power lines (CLs) can be disposed on the substrate 4010 for electrical connection between the driving portion 4070 and the sub-pixel portion 4060 and supplying driving power thereto, and the detailed description thereof will be omitted herein.

The first electrode portion 4020 can be configured to perform the role of a common electrode and a common power line, and the second electrode portion 4040 can be configured to perform the role of a data electrode and a data line (DL). Furthermore, the electrode portions 4020 and 4040 may also be configured to perform opposite roles.

The sub-pixel portion 4060 according to the present disclosure is a minimum unit region in which light is actually emitted, emits light of the same color, and includes a first and a second light emitting portion 4050a, 4050b spaced apart with a groove therebetween.

At least three sub-pixel portions adjacent to one another may constitute one unit pixel (or unit picture element) for color display. For example, one unit pixel may include a red sub-pixel portion, a green sub-pixel portion, and a blue sub-pixel portion adjacent to one another, and may further include a white pixel for luminance enhancement.

Moreover, a phosphor layer 4080 can be located on an outer surface of the sub-pixel portion 4060. For example, a light emitting portion, that is, semiconductor light emitting device, included in the sub-pixel portion 4060 is a blue semiconductor light emitting device that emits blue (B) light, and the phosphor layer 4080 performs a function of converting the blue(B) light into a color of the pixel. The phosphor layer 4080 can be a red phosphor 4081 or a green phosphor 4082 constituting an individual pixel.

In other words, a red phosphor 4081 capable of converting blue light into red (R) light can be deposited on a first sub-pixel portion at a position forming a red unit pixel, and a green phosphor 4082 capable of converting blue light into green (G) light can be deposited on a second sub-pixel portion adjacent to the first sub-pixel portion at a position forming a green unit pixel. In addition, only a blue semiconductor light emitting device can be used solely in a portion constituting a blue unit pixel. In this instance, the red (R), green (G) and blue (B) sub-pixel portions may form one pixel.

More specifically, as illustrated in FIG. 18, one color of phosphor can be deposited along the column direction. In this instance, a phosphor layer of the same color is coated on one sub-pixel portion 4060, and therefore, the phosphors of the same material can be deposited on the light emitting portions provided in the sub-pixel portion, the first and second light emitting portions, to convert light output from the first and second light emitting portions into the same color.

Further, the phosphor layer may also be formed to be deposited in the repair site 4050c. However, the present disclosure is not limited thereto, and instead of the phosphors, the semiconductor light emitting device 4050 and the quantum dot (QD) can be combined to form red (R), green (G) and blue (B) unit pixels. In addition, a black matrix 4091 can be disposed between each of the phosphor layers in order to enhance contrast. In other words, the black matrix 4091 may enhance the contrast of light and dark. However, the present disclosure is not limited thereto, and other structures for implementing blue, red and green may also be applied thereto.

Hereinafter, the sub-pixel portion 4060 according to the present disclosure will be described in more detail. As described above, the sub-pixel portion 4060 includes an empty space (or a repair site) 4050c in which the first and the second light emitting portion 4050a, 4050b and an additional light emitting portion (or semiconductor light emitting device) can be disposed.

On the drawing, it is illustrated that the sub-pixel portion 4060 includes two light emitting portions 4050a, 4050b, but the present disclosure is not limited thereto, and a larger number of light emitting portions can be provided in the sub-pixel portion 4060. The light emitting portion may also be referred to as a semiconductor light emitting device.

The first and second light emitting portions 4050a, 4050b included in the sub-pixel portion according to the present embodiment according to the invention include a first and a second conductive semiconductor layer 4053, 4055a, 4055b, an active layer 4054a, 4054b formed between the first and the second conductive semiconductor layer 4053, 4055a, 4055b, a first conductive electrode 4052a, 4052b formed on one surface of the first conductive semiconductor layer 4053, and a second conductive electrode 4056a, 4056b formed on one side of the second conductive semiconductor layer 4055a, 4055b, and the first conductive semiconductor layer 4053 of the first and the second light emitting portion 4050a, 4050b forms a single semiconductor layer.

Therefore, the second conductive semiconductor layer 4055a, the active layer 4054a and the second conductive electrode 4056a of the first light emitting portion 4050a, and the second conductive semiconductor layer 4055b, the active layer 4054b and the second conductive electrode 4056b of the second light emitting portion 4050b are formed on the single first conductive semiconductor layer 4053 to be spaced apart from each other with a groove therebetween.

The active layer 4054a, 4054b is formed on one surface of the single first conductive semiconductor layer 4053, and the first conductive electrode 4052a, 4052b of the first and the second light emitting portion 4050a, 4050b can be respectively provided on the other surface of the single first conductive semiconductor layer 4053. The first conductive electrodes 4052a, 4052b are formed at both sides of the other surface of the first conductive semiconductor layer 4053, respectively.

Further, the second electrode portion 4040 or wiring electrode includes a base electrode 4040-1 for transmitting the same electric signal to the first and the second light emitting portion 4050a, 4050b, a first sub-electrode 4040a extended from the base electrode 4040-1 and electrically connected to the first light emitting portion 4050a, and a second sub-electrode 4040b extended from the base electrode 4040-1 and electrically connected to the second light emitting portion 4050b..

Moreover, the wiring electrode (or second electrode portion 4040) may further include a third sub-electrode 4040c extended from the base electrode 4040-1 toward the repair site 4050c. The sub-electrodes provided on the wiring electrode can be provided in proportion to a number of the light emitting portions and a number of the repair sites provided in the sub-pixel portion.

The same data signal is transmitted to the first through third sub-electrodes 4040a, 4040b, 4040c, respectively, and the light emitting portions provided in the sub-pixel portion 4060 may emit light based on the same data signal. Further, the first and the second sub-electrode 4040a, 4040b are extended from the base electrode 4040-1 and electrically connected to the respective light emitting portions, and electrically connected to an electrode provided on a specific conductive semiconductor layer provided in each light emitting portion.

Further, FIGS. 18 and 19 illustrate views in which the light emitting portion (or the semiconductor light emitting device) is not additionally disposed in the repair site 4050c. However, when the light emitting portion is additionally provided in the repair site 4050c, the additionally provided light emitting portion and the third sub-electrode 4040c can be electrically connected to each other.

As described above, a plurality of light emitting portions 4050a, 4050b included in the same sub-pixel portion 4060 are configured to emit light based on a signal transmitted through a plurality of sub-electrodes 4040a, 4040b that are branched from the base electrode 4040-1. The first conductive electrode 4052a included in the first light emitting portion 4050a can be electrically connected to the first sub-electrode 4040a, and the second conductive electrode 4052b included in the second light emitting portion 4050b can be electrically connected to the second sub-electrode 4040b.

According to a display device according to the present disclosure, in order to remove a light emitting portion corresponding to an NG cell, a laser is irradiated to the single first semiconductor layer 4053 to allow the first and the second light emitting portion 4050a, 4050b to be physically separated.

In addition, laser ablation is used, and through this, though not shown in the drawing, a crack can be formed on a cross-section 4059a of the first semiconductor layer 4053 irradiated with the laser. In the display device according to the present disclosure, when there is a light emitting portion corresponding to an NG cell, the single first semiconductor layer 4053 can be cracked using laser ablation, and then the light emitting portion corresponding to the NG cell can be removed.

Then, a new semiconductor light emitting device can be inserted into the repair site 4050c. Through this, the sub-pixel portion 4060 can be provided with at least two light emitting portions that are free from defects to emit light of the same brightness as that of the other sub-pixel portions 4060. Further, in the above description, an example of removing a defective light emitting portion has been described, but according to the present disclosure, it may also be possible to insert a new semiconductor light emitting device into the repair site while maintaining the defective light emitting portion without removing it.

According to the present embodiment having the foregoing configuration, a plurality of semiconductor light emitting devices that share at least one semiconductor layer can be included in one unit cell (sub-pixel portion). In other words, the unit cell can be provided with a plurality of semiconductor light emitting devices that share one semiconductor layer other than a plurality of physically separated semiconductor light emitting devices, thereby reducing the complexity of the process of transferring them to a substrate.

Also, an empty space can be provided in the unit cell, and a new semiconductor light emitting device can be disposed in the empty space provided in the unit cell including a defective semiconductor light emitting device. Therefore, even when a defective semiconductor light emitting device is included in the unit cell, the display device according to the present disclosure may additionally arrange a semiconductor light emitting device that can replace the semiconductor light emitting device, thereby facilitating the replacement of the defective semiconductor light emitting device.

In addition, a plurality of semiconductor light emitting devices included in the unit cell and sub-electrodes branched respectively into empty spaces can be provided to remove a defective semiconductor light emitting device or not to perform additional wiring even when a new semiconductor light emitting device is disposed in an empty space, thereby more conveniently removing and replacing the semiconductor light emitting device.

The present invention encompasses various modifications to each of the examples and embodiments discussed herein, within the scope defined by the appended claims. According to the invention, one or more features described above in one embodiment or example can be equally applied to another embodiment or example described above, within the scope defined by the appended claims. The features of one or more embodiments or examples described above can be combined into each of the embodiments or examples described above, within the scope defined by the appended claims. Any full or partial combination of one or more embodiment or examples of the invention, within the scope defined by the appended claims, is also part of the invention.

As the present invention may be embodied in several forms without departing from the essential characteristics thereof, it should also be understood that the above-described embodiments are not limited by any of the details of the foregoing description, unless otherwise specified, but rather should be construed broadly within its scope as defined in the appended claims, and therefore all changes and modifications that fall within the metes and bounds of the claims are therefore intended to be embraced by the appended claims.

## Claims

1. A display device (1000), comprising:
a substrate (1010);
a sub-pixel portion (1060) disposed on the substrate (1010); and
a wiring electrode electrically connected to the sub-pixel portion (1060),
wherein the sub-pixel portion (1060) comprises:
a first light emitting portion (1050a) and a second light emitting portion (1050b) configured to output light of a same color and spaced apart with a groove therebetween,
wherein the wiring electrode comprises:
a base electrode (1040-1) configured to transmit a same electric signal to the first light emitting portion (1050a) and the second light emitting portion (1050b),
a first sub-electrode (1040a) extended from the base electrode (1040-1) and electrically connected to the first light emitting portion (1050a), and
a second sub-electrode (1040b) extended from the base electrode (1040-1) and electrically connected to the second light emitting portion (1050b), and
wherein the first light emitting portion (1050a) and the second light emitting portion (1050b) share at least one semiconductor layer.

2. The display device (1000) of claim 1,
wherein the sub-pixel portion (1060) further comprises an undoped semiconductor layer (1059), and
wherein the first light emitting portion (1050a) and the second light emitting portion (1050b) are respectively etched on the undoped semiconductor layer (1059) with the groove therebetween.

3. The display device (1000) of claim 2, wherein the first light emitting portion (1050a) and the second light emitting portion (1050b) etched on the undoped semiconductor layer (1059) respectively comprise:
a first conductive semiconductor layer (1053a, 1053b) and a second conductive semiconductor layer (1056a, 1056b);
an active layer (1054a, 1054b) formed between the first conductive semiconductor layer (1053a, 1053b) and the second conductive semiconductor layer (1055a, 1055b);
a first conductive electrode (1052a, 1052b) formed on one surface of the first conductive semiconductor layer (1053a, 1053b); and
a second conductive electrode (1056a, 1056b) formed on one surface of the second conductive semiconductor layer (1055a, 1055b),
wherein the first conductive electrode (1052a, 1052b) included in the first light emitting portion (1050a) is electrically connected to the first sub-electrode (1040a),
wherein the first conductive electrode (1052a, 1052b) included in the second light emitting portion (1050b) is electrically connected to the second sub-electrode (1040b).

4. The display device (1000) of claim 3,
wherein at least part of the undoped semiconductor layer (1059) is configured to be cracked between the first light emitting portion (1050a) and the second light emitting portion (1050b) to disconnect a defective light emitting portion to drive only remaining light emitting portions included in the sub-pixel portion (1060), and
wherein preferably the first light emitting portion (1050a) and the second light emitting portion (1050b) are physically separated by the crack.

5. The display device (1000) of claim 1,
wherein the sub-pixel portion (1060) further includes at least one repair site (1050c) in which a semiconductor light emitting device can be disposed, and
wherein the wiring electrode preferably further comprises a third sub-electrode extended from the base electrode (1040-1) to face the repair site (1050c).

6. The display device (1000) of claim 1, wherein the first light emitting portion (1050a) and the second light emitting portion (1050b) emit light based on a same data signal transmitted to the first sub-electrode (1040a) and the second sub-electrode (1040b) through the base electrode (1040-1).

7. The display device (1000) of claim 1, further comprising:
a phosphor layer covering at least part of the sub-pixel portion (1060), and configured to convert the color of light output from the first light emitting portion (1050a) and the second light emitting portion (1050b) provided in the sub-pixel portion (1060),
wherein phosphors of a same material are etched on the first light emitting portion (1050a) and the second light emitting portion (1050b) to convert the light output from the first light emitting portion (1050a) and the second light emitting portion (1050b) into the same color.

8. The display device (1000) of claim 1, wherein the first light emitting portion (1050a) and the second light emitting portion (1050b) respectively comprise:
a first conductive semiconductor layer (1053a, 1053b) and a second conductive semiconductor layer (1055a, 1055b);
an active layer (1054a, 1054b) formed between the first conductive semiconductor layer (1053a, 1053b) and the second conductive semiconductor layer (1055a, 1055b);
a first conductive electrode (1052a, 1052b) formed on one surface of the first conductive semiconductor layer (1053a, 1053b); and
a second conductive electrode (1056a, 1056b) formed on one surface of the second conductive semiconductor layer (1055a, 1055b), and
wherein the first conductive semiconductor layer (1053a, 1053b) of the first light emitting portion (1050a) and the second light emitting portion (1050b) forms a single first semiconductor layer.

9. The display device (1000) of claim 8, wherein the second conductive semiconductor layer (1055a, 1055b), the active layer (1054a, 1054b), and the second conductive electrode (1056a, 1056b) of the first light emitting portion (1050a) are spaced apart from the second conductive semiconductor layer (1055a, 1055b), the active layer (1054a, 1054b), and the second conductive electrode (1056a, 1056b) of the second light emitting portion (1050b) with the groove therebetween on the single first conductive semiconductor layer (1053a, 1053b).

10. The display device (1000) of claim 9, wherein the active layer (1054a, 1054b) of the first light emitting portion (1050a) and the second light emitting portion (1050b) are respectively provided on one surface of the single first conductive semiconductor layer (1053a, 1053b), and
wherein the first conductive electrodes (1052a, 1052b) of the first light emitting portion (1050a) and the second light emitting portion (1050b) are respectively provided on the other surface of the single first conductive semiconductor layer (1053a, 1053b).

11. The display device (1000) of claim 10,
wherein the first conductive electrodes (1052a, 1052b) of the first light emitting portion (1050a) and the second light emitting portion (1050b) are respectively provided at both sides of the other surface of the single first conductive semiconductor layer (1053a, 1053b), and
wherein preferably at least part of the single first conductive semiconductor layer (1053a, 1053b) is configured to be cracked to disconnect a defective light emitting portion to drive only remaining light emitting portions included in the sub-pixel portion (1060) and wherein more preferably an electrical connection of the first light emitting portion (1050a) and the second light emitting portion (1050b) is isolated by the crack.

12. A method of manufacturing a display device (1000), the method comprising:
forming a sub-pixel portion (1060) on a substrate (1010); and
forming a wiring electrode to be electrically connected to the sub-pixel portion (1060),
wherein forming the sub-pixel portion (1060) comprises:
forming a first light emitting portion (1050a) and a second light emitting portion (1050b) to output light of a same color and spaced apart with a groove therebetween, and
wherein forming the wiring electrode comprises:
forming a base electrode (1040-1) to transmit a same electric signal to the first light emitting portion (1050a) and the second light emitting portion (1050b);
forming a first sub-electrode (1040a) extended from the base electrode (1040-1) and to be electrically connected to the first light emitting portion (1050a); and
forming a second sub-electrode (1040b) extended from the base electrode (1040-1) and electrically connected to the second light emitting portion (1050b), and
wherein the first light emitting portion (1050a) and the second light emitting portion (1050b) share at least one semiconductor layer.

13. The method of claim 12, wherein the sub-pixel portion (1060) further comprises an undoped semiconductor layer (1059), and
wherein the first light emitting portion (1050a) and the second light emitting portion (1050b) are respectively etched on the undoped semiconductor layer (1059) with the groove therebetween.

14. The method of claim 13, wherein the first light emitting portion (1050a) and the second light emitting portion (1050b) etched on the undoped semiconductor layer (1059) respectively comprise:
a first conductive semiconductor layer (1053a, 1053b) and a second conductive semiconductor layer (1055a, 1055b);
an active layer (1054a, 1054b) formed between the first conductive semiconductor layer (1053a, 1053b) and the second conductive semiconductor layer (1055a, 1055b);
a first conductive electrode (1052a, 1052b) formed on one surface of the first conductive semiconductor layer (1053a, 1053b); and
a second conductive electrode (1056a, 1056b) formed on one surface of the second conductive semiconductor layer (1055a, 1055b),
wherein the first conductive electrode (1052a, 1052b) included in the first light emitting portion (1050a) is electrically connected to the first sub-electrode (1040a), and
wherein the first conductive electrode (1052a, 1052b) included in the second light emitting portion (1050b) is electrically connected to the second sub-electrode (1040b).

15. The method of claim 14, wherein at least part of the undoped semiconductor layer (1059) is cracked between the first light emitting portion (1050a) and the second light emitting portion (1050b) to disconnect a defective light emitting portion to drive only remaining light emitting portions included in the sub-pixel portion (1060).

## Patentansprüche

1. Anzeigevorrichtung (1000), umfassend:
ein Substrat (1010);
einen Subpixelabschnitt (1060), der auf dem Substrat (1010) angeordnet ist; und
eine Verdrahtungselektrode, die elektrisch mit dem Subpixelabschnitt (1060) verbunden ist,
wobei der Subpixelabschnitt (1060) umfasst:
einen ersten lichtemittierenden Abschnitt (1050a) und einen zweiten lichtemittierenden Abschnitt (1050b), die dazu ausgelegt sind, Licht derselben Farbe auszugeben und die durch eine dazwischenliegende Nut beabstandet sind,
wobei die Verdrahtungselektrode umfasst:
eine Basiselektrode (1040-1), die dazu ausgelegt ist, ein gleiches elektrisches Signal an den ersten lichtemittierenden Abschnitt (1050a) und den zweiten lichtemittierenden Abschnitt (1050b) zu übermitteln,
eine erste Unterelektrode (1040a), die sich ausgehend von der Basiselektrode (1040-1) erstreckt und elektrisch mit dem ersten lichtemittierenden Abschnitt (1050a) verbunden ist, und
eine zweite Unterelektrode (1040b), die sich ausgehend von der Basiselektrode (1040-1) erstreckt und elektrisch mit dem zweiten lichtemittierenden Abschnitt (1050b) verbunden ist,
wobei der erste lichtemittierende Abschnitt (1050a) und der zweite lichtemittierende Abschnitt (1050b) sich zumindest eine Halbleiterschicht teilen.

2. Anzeigevorrichtung (1000) nach Anspruch 1,
wobei der Subpixelabschnitt (1060) ferner eine undotierte Halbleiterschicht (1059) umfasst, und
wobei der erste lichtemittierende Abschnitt (1050a) und der zweite lichtemittierende Abschnitt (1050b) jeweils mit der dazwischenliegenden Nut auf die undotierte Halbleiterschicht (1059) geätzt sind.

3. Anzeigevorrichtung (1000) nach Anspruch 2, wobei der erste lichtemittierende Abschnitt (1050a) und der zweite lichtemittierende Abschnitt (1050b), die auf die undotierte Halbleiterschicht (1059) geätzt sind, jeweils umfassen:
eine erste leitende Halbleiterschicht (1053a, 1053b) und eine zweite leitende Halbleiterschicht (1056a, 1056b);
eine aktive Schicht (1054a, 1054b), die zwischen der ersten leitenden Halbleiterschicht (1053a, 1053b) und der zweiten leitenden Halbleiterschicht (1055a, 1055b) ausgebildet ist;
eine erste leitende Elektrode (1052a, 1052b), die auf einer Oberfläche der ersten leitenden Halbleiterschicht (1053a, 1053b) ausgebildet ist; und
eine zweite leitende Elektrode (1056a, 1056b), die auf einer Oberfläche der zweiten leitenden Halbleiterschicht (1055a, 1055b) ausgebildet ist,
wobei die erste leitende Elektrode (1052a, 1052b), die in dem ersten lichtemittierenden Abschnitt (1050a) enthalten ist, mit der ersten Unterelektrode (1040a) elektrisch verbunden ist,
wobei die erste leitende Elektrode (1052a, 1052b), die in dem zweiten lichtemittierenden Abschnitt (1050b) enthalten ist, mit der zweiten Unterelektrode (1040b) elektrisch verbunden ist.

4. Anzeigevorrichtung (1000) nach Anspruch 3,
wobei zumindest ein Teil der undotierten Halbleiterschicht (1059) dazu ausgelegt ist, zwischen dem ersten lichtemittierenden Abschnitt (1050a) und dem zweiten lichtemittierenden Abschnitt (1050b) gespalten zu werden, um einen defekten lichtemittierenden Abschnitt abzutrennen, um nur die verbleibenden lichtemittierenden Abschnitte anzusteuern, die in dem Subpixelabschnitt (1060) enthalten sind, und
wobei bevorzugt der erste lichtemittierende Abschnitt (1050a) und der zweite lichtemittierende Abschnitt (1050b) durch den Spalt physisch getrennt werden.

5. Anzeigevorrichtung (1000) nach Anspruch 1,
wobei der Subpixelabschnitt (1060) ferner zumindest eine Reparaturstelle (1050c) aufweist, in der ein lichtemittierendes Halbleiterbauteil angeordnet werden kann, und
wobei die Verdrahtungselektrode bevorzugt weiterhin eine dritte Unterelektrode umfasst, die sich ausgehend von der Basiselektrode (1040-1) erstreckt, um der Reparaturstelle (1050c) gegenüberzuliegen.

6. Anzeigevorrichtung (1000) nach Anspruch 1, wobei der erste lichtemittierende Abschnitt (1050a) und der zweite lichtemittierende Abschnitt (1050b) Licht auf der Grundlage desselben Datensignals emittieren, das durch die Basiselektrode (1040-1) an die erste Unterelektrode (1040a) und die zweite Unterelektrode (1040b) übermittelt wird.

7. Anzeigevorrichtung (1000) nach Anspruch 1, ferner umfassend:
eine Phosphorschicht, die zumindest einen Teil des Subpixelabschnitts (1060) bedeckt und dazu ausgelegt ist, die Farbe des Lichts umzuwandeln, das von dem ersten lichtemittierenden Abschnitt (1050a) und dem zweiten lichtemittierenden Abschnitt (1050b) ausgegeben wird, die in dem Subpixelabschnitt (1060) vorgesehen sind.
wobei Leuchtstoffe desselben Materials auf den ersten lichtemittierenden Abschnitt (1050a) und den zweiten lichtemittierenden Abschnitt (1050b) geätzt sind, um das von dem ersten lichtemittierenden Abschnitt (1050a) und dem zweiten lichtemittierenden Abschnitt (1050b) ausgegebene Licht in dieselbe Farbe umzuwandeln.

8. Anzeigevorrichtung (1000) nach Anspruch 1, wobei der erste lichtemittierende Abschnitt (1050a) und der zweite lichtemittierende Abschnitt (1050b) jeweils umfassen:
eine erste leitende Halbleiterschicht (1053a, 1053b) und eine zweite leitende Halbleiterschicht (1055a, 1055b);
eine aktive Schicht (1054a, 1054b), die zwischen der ersten leitenden Halbleiterschicht (1053a, 1053b) und der zweiten leitenden Halbleiterschicht (1055a, 1055b) ausgebildet ist;
eine erste leitende Elektrode (1052a, 1052b), die auf einer Oberfläche der ersten leitenden Halbleiterschicht (1053a, 1053b) ausgebildet ist; und
eine zweite leitende Elektrode (1056a, 1056b), die auf einer Oberfläche der zweiten leitenden Halbleiterschicht (1055a, 1055b) ausgebildet ist, und wobei die erste leitende Halbleiterschicht (1053a, 1053b) des ersten lichtemittierenden Abschnitts (1050a) und des zweiten lichtemittierenden Abschnitts (1050b) eine einzelne erste Halbleiterschicht bildet.

9. Anzeigevorrichtung (1000) nach Anspruch 8, wobei die zweite leitende Halbleiterschicht (1055a, 1055b), die aktive Schicht (1054a, 1054b) und die zweite leitende Elektrode (1056a, 1056b) des ersten lichtemittierenden Abschnitts (1050a) von der zweiten leitenden Halbleiterschicht (1055a, 1055b), der aktiven Schicht (1054a, 1054b) und der zweiten leitenden Elektrode (1056a, 1056b) des zweiten lichtemittierenden Abschnitts (1050b) durch die dazwischenliegende Nut auf der einzelnen ersten leitenden Halbleiterschicht (1053a, 1053b) beabstandet sind.

10. Anzeigevorrichtung (1000) nach Anspruch 9, wobei die aktiven Schichten (1054a, 1054b) des ersten lichtemittierenden Abschnitts (1050a) und des zweiten lichtemittierenden Abschnitts (1050b) jeweils auf einer Oberfläche der einzelnen ersten leitenden Halbleiterschicht (1053a, 1053b) vorgesehen sind, und
wobei die ersten leitenden Elektroden (1052a, 1052b) des ersten lichtemittierenden Abschnitts (1050a) und des zweiten lichtemittierenden Abschnitts (1050b) jeweils auf der anderen Oberfläche der einzelnen ersten leitenden Halbleiterschicht (1053a, 1053b) vorgesehen sind.

11. Anzeigevorrichtung (1000) nach Anspruch 10,
wobei die ersten leitenden Elektroden (1052a, 1052b) des ersten lichtemittierenden Abschnitts (1050a) und des zweiten lichtemittierenden Abschnitts (1050b) jeweils auf beiden Seiten der anderen Oberfläche der einzelnen ersten leitenden Halbleiterschicht (1053a, 1053b) vorgesehen sind, und
wobei bevorzugt zumindest ein Teil der einzelnen ersten leitenden Halbleiterschicht (1053a, 1053b) dazu ausgelegt ist, gespalten zu werden, um einen defekten lichtemittierenden Abschnitt abzutrennen, um nur die verbleibenden lichtemittierenden Abschnitte, die in dem Subpixelabschnitt (1060) enthalten sind, anzusteuern, und wobei weiter bevorzugt eine elektrische Verbindung des ersten lichtemittierenden Abschnitts (1050a) und des zweiten lichtemittierenden Abschnitts (1050b) durch den Spalt getrennt wird.

12. Verfahren zum Herstellen einer Anzeigevorrichtung (1000), wobei das Verfahren umfasst:
Ausbilden eines Subpixelabschnitts (1060) auf einem Substrat (1010); und
Ausbilden einer Verdrahtungselektrode zur elektrischen Verbindung mit dem Subpixelabschnitt (1060),
wobei das Ausbilden des Subpixelabschnitts (1060) umfasst:
Ausbilden eines ersten lichtemittierenden Abschnitts (1050a) und eines zweiten lichtemittierenden Abschnitts (1050b) zum Ausgeben von Licht derselben Farbe, die durch eine dazwischenliegende Nut beabstandet sind, und
wobei das Ausbilden der Verdrahtungselektrode umfasst:
Ausbilden einer Basiselektrode (1040-1), um ein gleiches elektrisches Signal an den ersten lichtemittierenden Abschnitt (1050a) und an den zweiten lichtemittierenden Abschnitt (1050b) zu übermitteln;
Ausbilden einer ersten Unterelektrode (1040a), die sich ausgehend von der Basiselektrode (1040-1) erstreckt und elektrisch mit dem ersten lichtemittierenden Abschnitt (1050a) verbunden wird; und
Ausbilden einer zweiten Unterelektrode (1040b), die sich ausgehend von der Basiselektrode (1040-1) erstreckt und elektrisch mit dem zweiten lichtemittierenden Abschnitt (1050b) verbunden wird, und
wobei der erste lichtemittierende Abschnitt (1050a) und der zweite lichtemittierende Abschnitt (1050b) sich zumindest eine Halbleiterschicht teilen.

13. Verfahren nach Anspruch 12, wobei der Subpixelabschnitt (1060) ferner eine undotierte Halbleiterschicht (1059) umfasst, und
wobei der erste lichtemittierende Abschnitt (1050a) und der zweite lichtemittierende Abschnitt (1050b) jeweils mit der dazwischenliegenden Nut auf die undotierte Halbleiterschicht (1059) geätzt werden.

14. Verfahren nach Anspruch 13, wobei der erste lichtemittierende Abschnitt (1050a) und der zweite lichtemittierende Abschnitt (1050b), die auf die undotierte Halbleiterschicht (1059) geätzt werden, jeweils umfassen:
eine erste leitende Halbleiterschicht (1053a, 1053b) und eine zweite leitende Halbleiterschicht (1055a, 1055b);
eine aktive Schicht (1054a, 1054b), die zwischen der ersten leitenden Halbleiterschicht (1053a, 1053b) und der zweiten leitenden Halbleiterschicht (1055a, 1055b) ausgebildet ist;
eine erste leitende Elektrode (1052a, 1052b), die auf einer Oberfläche der ersten leitenden Halbleiterschicht (1053a, 1053b) ausgebildet ist; und
eine zweite leitende Elektrode (1056a, 1056b), die auf einer Oberfläche der zweiten leitenden Halbleiterschicht (1055a, 1055b) ausgebildet ist,
wobei die erste leitende Elektrode (1052a, 1052b), die in dem ersten lichtemittierenden Abschnitt (1050a) enthalten ist, mit der ersten Unterelektrode (1040a) elektrisch verbunden ist, und
wobei die erste leitende Elektrode (1052a, 1052b), die in dem zweiten lichtemittierenden Abschnitt (1050b) enthalten ist, mit der zweiten Unterelektrode (1040b) elektrisch verbunden ist.

15. Verfahren nach Anspruch 14, wobei zumindest ein Teil der undotierten Halbleiterschicht (1059) zwischen dem ersten lichtemittierenden Abschnitt (1050a) und dem zweiten lichtemittierenden Abschnitt (1050b) gespalten wird, um einen defekten lichtemittierenden Abschnitt abzutrennen, um nur verbleibende lichtemittierende Abschnitte, die in dem Subpixelabschnitt (1060) enthalten sind, anzusteuern.

## Revendications

1. Dispositif d'affichage (1000) comprenant :
un substrat (1010) ;
une partie de sous-pixel (1060) disposée sur le substrat (1010) ; et
une électrode de câblage connectée électriquement à la partie de sous-pixel (1060),
dans lequel la partie de sous-pixel (1060) comprend :
une première partie électroluminescente (1050a) et une seconde partie électroluminescente (1050b) configurées pour émettre de la lumière d'une même couleur et espacées l'une de l'autre par une rainure entre elles,
dans lequel l'électrode de câblage comprend :
une électrode de base (1040-1) configurée pour transmettre un même signal électrique à la première partie électroluminescente (1050a) et à la seconde partie électroluminescente (1050b),
une première sous-électrode (1040a) s'étendant depuis l'électrode de base (1040-1) et connectée électriquement à la première partie électroluminescente (1050a), et
une deuxième sous-électrode (1040b) s'étendant depuis l'électrode de base (1040-1) et connectée électriquement à la seconde partie électroluminescente (1050b), et
dans lequel la première partie électroluminescente (1050a) et la seconde partie électroluminescente (1050b) partagent au moins une couche à semi-conducteurs.

2. Dispositif d'affichage (1000) selon la revendication 1,
dans lequel la partie de sous-pixel (1060) comprend en outre une couche à semi-conducteurs non dopée (1059), et
dans lequel la première partie électroluminescente (1050a) et la seconde partie électroluminescente (1050b) sont gravées respectivement sur la couche à semi-conducteurs (1059) non dopée avec la rainure entre elles.

3. Dispositif d'affichage (1000) selon la revendication 2, dans lequel la première partie électroluminescente (1050a) et la seconde partie électroluminescente (1050b) gravées sur la couche à semi-conducteurs non dopée (1059) comprennent respectivement :
une première couche à semi-conducteurs conductrice (1053a, 1053b) et une seconde couche à semi-conducteurs conductrice (1056a, 1056b) ;
une couche active (1054a, 1054b) formée entre la première couche à semi-conducteurs conductrice (1053a, 1053b) et la seconde couche à semi-conducteurs conductrice (1055a, 1055b) ;
une première électrode conductrice (1052a, 1052b) formée sur une surface de la première couche à semi-conducteurs conductrice (1053a, 1053b) ; et
une seconde électrode conductrice (1056a, 1056b) formée sur une surface de la seconde couche à semi-conducteurs conductrice (1055a, 1055b),
dans lequel la première électrode conductrice (1052a, 1052b) comprise dans la première partie électroluminescente (1050a) est connectée électriquement à la première sous-électrode (1040a),
dans lequel la première électrode conductrice (1052a, 1052b) comprise dans la seconde partie électroluminescente (1050b) est connectée électriquement à la deuxième sous-électrode (1040b).

4. Dispositif d'affichage (1000) selon la revendication 3,
dans lequel au moins une partie de la couche à semi-conducteurs non dopée (1059) est configurée pour être fissurée entre la première partie électroluminescente (1050a) et la seconde partie électroluminescente (1050b) pour déconnecter une partie électroluminescente défectueuse pour entraîner seulement des parties électroluminescentes restantes comprises dans la partie de sous-pixel (1060), et
dans lequel de manière préférée la première partie électroluminescente (1050a) et la seconde partie électroluminescente (1050b) sont physiquement séparées par la fissure.

5. Dispositif d'affichage (1000) selon la revendication 1,
dans lequel la partie de sous-pixel (1060) comporte en outre au moins un site de réparation (1050c) sur lequel un dispositif électroluminescent à semi-conducteurs peut être disposé, et
dans lequel l'électrode de câblage comprend de manière préférée en outre une troisième sous-électrode s'étendant depuis l'électrode de base (1040-1) pour faire face au site de réparation (1050c).

6. Dispositif d'affichage (1000) selon la revendication 1, dans lequel la première partie électroluminescente (1050a) et la seconde partie électroluminescente (1050b) émettent de la lumière sur la base d'un même signal de données transmis à la première sous-électrode (1040a) et à la deuxième sous-électrode (1040b) par l'intermédiaire de l'électrode de base (1040-1).

7. Dispositif d'affichage (1000) selon la revendication 1, comprenant en outre :
une couche de phosphore recouvrant au moins une partie de la partie de sous-pixel (1060), et configurée pour convertir la couleur de la lumière délivrée en sortie depuis la première partie électroluminescente (1050a) et la seconde partie électroluminescente (1050b) fournie dans la partie de sous-pixel (1060), dans lequel des phosphores d'un même matériau sont gravés sur la première partie électroluminescente (1050a) et la seconde partie électroluminescente (1050b) pour convertir la lumière délivrée en sortie depuis la première partie électroluminescente (1050a) et la seconde partie électroluminescente (1050b) dans la même couleur.

8. Dispositif d'affichage (1000) selon la revendication 1, dans lequel la première partie électroluminescente (1050a) et la seconde partie électroluminescente (1050b) comprennent respectivement :
une première couche à semi-conducteurs conductrice (1053a, 1053b) et une seconde couche à semi-conducteurs conductrice (1055a, 1055b) ;
une couche active (1054a, 1054b) formée entre la première couche à semi-conducteurs conductrice (1053a, 1053b) et la seconde couche à semi-conducteurs conductrice (1055a, 1055b) ;
une première électrode conductrice (1052a, 1052b) formée sur une surface de la première couche à semi-conducteurs conductrice (1053a, 1053b) ; et
une seconde électrode conductrice (1056a, 1056b) formée sur une surface de la seconde couche à semi-conducteurs conductrice (1055a, 1055b), et
dans lequel la première couche à semi-conducteurs conductrice (1053a, 1053b) de la première partie électroluminescente (1050a) et de la seconde partie électroluminescente (1050b) forment une première couche à semi-conducteurs unique.

9. Dispositif d'affichage (1000) selon la revendication 8, dans lequel la seconde couche à semi-conducteurs conductrice (1055a, 1055b), la couche active (1054a, 1054b) et la seconde électrode conductrice (1056a, 1056b) de la première partie électroluminescente (1050a) sont espacées de la seconde couche à semi-conducteurs conductrice (1055a, 1055b), de la couche active (1054a, 1054b), et de la seconde électrode conductrice (1056a, 1056b) de la deuxième partie électroluminescente (1050b) par la rainure entre elles sur l'unique première couche à semi-conducteurs conductrice (1053a, 1053b).

10. Dispositif d'affichage (1000) selon la revendication 9, dans lequel la couche active (1054a, 1054b) de la première partie électroluminescente (1050a) et de la seconde partie électroluminescente (1050b) sont fournies respectivement sur une surface de l'unique première couche à semi-conducteurs conductrice (1053a, 1053b), et
dans lequel les premières électrodes conductrices (1052a, 1052b) de la première partie électroluminescente (1050a) et de la seconde partie électroluminescente (1050b) sont fournies respectivement sur l'autre surface de l'unique première couche à semi-conducteurs conductrice (1053a, 1053b).

11. Dispositif d'affichage (1000) selon la revendication 10,
dans lequel les premières électrodes conductrices (1052a, 1052b) de la première partie électroluminescente (1050a) et de la seconde partie électroluminescente (1050b) sont fournies respectivement sur les deux côtés de l'autre surface de l'unique première couche à semi-conducteurs conductrice (1053a, 1053b), et
dans lequel de manière préférée au moins une partie de l'unique première couche à semi-conducteurs conductrice (1053a, 1053b) est configurée pour être fissurée pour se déconnecter d'une partie électroluminescente défectueuse pour entraîner seulement des parties électroluminescentes restantes comprises dans la partie de sous-pixel (1060) et dans lequel de manière davantage préférée une connexion électrique de la première partie électroluminescente (1050a) et de la seconde partie électroluminescente (1050b) est isolée par la fissure.

12. Procédé de fabrication d'un dispositif d'affichage (1000), le procédé comprenant :
la formation d'une partie de sous-pixel (1060) sur un substrat (1010) ; et
la formation d'une électrode de câblage pour être connectée électriquement à la partie de sous-pixel (1060),
dans lequel la formation de la partie de sous-pixel (1060) comprend :
la formation d'une première partie électroluminescente (1050a) et d'une seconde partie électroluminescente (1050b) pour délivrer en sortie de la lumière d'une même couleur et espacées l'une de l'autre par une rainure entre elles, et
dans lequel la formation de l'électrode de câblage comprend :
la formation d'une électrode de base (1040-1) pour transmettre un même signal électrique à la première partie électroluminescente (1050a) et à la seconde partie électroluminescente (1050b) ;
la formation d'une première sous-électrode (1040a) s'étendant depuis l'électrode de base (1040-1) et pour être connectée électriquement à la première partie électroluminescente (1050a) ; et
la formation d'une deuxième sous-électrode (1040b) s'étendant depuis l'électrode de base (1040-1) et connectée électriquement à la seconde partie électroluminescente (1050b),
et
dans lequel la première partie électroluminescente (1050a) et la seconde partie électroluminescente (1050b) partagent au moins une couche à semi-conducteurs.

13. Procédé selon la revendication 12, dans lequel la partie de sous-pixel (1060) comprend en outre une couche à semi-conducteurs non dopée (1059), et dans lequel la première partie électroluminescente (1050a) et la seconde partie électroluminescente (1050b) sont gravées respectivement sur la couche à semi-conducteurs non dopée (1059) avec la rainure entre elles.

14. Procédé selon la revendication 13, dans lequel la première partie électroluminescente (1050a) et la seconde partie électroluminescente (1050b) gravées sur la couche à semi-conducteurs non dopée (1059) respectivement comprennent :
une première couche à semi-conducteurs conductrice (1053a, 1053b) et une seconde couche à semi-conducteurs conductrice (1055a, 1055b) ;
une couche active (1054a, 1054b) formée entre la première couche à semi-conducteurs conductrice (1053a, 1053b) et la seconde couche à semi-conducteurs conductrice (1055a, 1055b) ;
une première électrode conductrice (1052a, 1052b) formée sur une surface de la première couche à semi-conducteurs conductrice (1053a, 1053b) ; et
une seconde électrode conductrice (1056a, 1056b) formée sur une surface de la seconde couche à semi-conducteurs conductrice (1055a, 1055b),
dans lequel la première électrode conductrice (1052a, 1052b) comprise dans la première partie électroluminescente (1050a) est connectée électriquement à la première sous-électrode (1040a), et
dans lequel la première électrode conductrice (1052a, 1052b) comprise dans la seconde partie électroluminescente (1050b) est connectée électriquement à la deuxième sous-électrode (1040b).

15. Procédé selon la revendication 14, dans lequel au moins une partie de la couche à semi-conducteurs non dopée (1059) est fissurée entre la première partie électroluminescente (1050a) et la seconde partie électroluminescente (1050b) pour déconnecter une partie électroluminescente défectueuse pour entraînement seulement des parties électroluminescentes restantes comprises dans la partie de sous-pixel (1060).
